# EUROPÄISCHE PATENTSCHRIFT

(11) **EP 2 226 747 B1**
(45) Veröffentlichungstag und Bekanntmachung des Hinweises auf die Patenterteilung: **27.06.2012**
(21) Anmeldenummer: 10155491.3
(22) Anmeldetag: 04.03.2010
(51) Int. Cl.: H05K 1/18, F16B 5/02, G06K 19/073, G06K 19/077, H05K 3/10, H01F 41/04, F16B 17/00, F16B 41/00

(54) **Verfahren und Vorrichtung zur Erzeugung eines Schaltungsmusters auf einem Substrat**
Method and device for creating a wiring pattern on a substrate
Procédé et dispositif de production d'un motif de câblage sur un substrat

(30) Priorität: 07.03.2009 DE 102009012255
(43) Veröffentlichungstag der Anmeldung: 08.09.2010
(73) Patentinhaber: Smartrac IP B.V., 1077 XX Amsterdam (NL)
(72) Erfinder: Michalk, Manfred, 99092 Erfurt (DE)
(74) Vertreter: advotec.

(56) Entgegenhaltungen:
- EP-A1- 1 145 609
- EP-A2- 0 689 164
- DE-A1- 3 122 880
- DE-A1- 19 855 023
- DE-A1- 19 920 593
- US-A- 6 111 303
- US-A1- 2002 179 234
- US-A1- 2003 085 454
- US-A1- 2005 161 783

## Beschreibung

Die Erfindung betrifft ein Verfahren zur Erzeugung eines Schaltungsmusters auf einem Substrat nach den Merkmalen des Oberbegriffs des Anspruchs 1. Des Weiteren betrifft die Erfindung eine Vorrichtung zur Erzeugung eines Schaltungsmusters auf einem Substrat nach den Merkmalen des Oberbegriffs des Anspruchs 9.

Aus dem Stand der Technik sind bereits Halbfabrikate zur Herstellung von Sicherheitsdokumenten, wie beispielsweise Smart Cards, Kreditkarten, elektronischen Personalausweisen oder elektronischen Gesundheitskarten, bekannt. Derartige Halbfabrikate sind zum Beispiel so genannte Prelaminate oder funktionelle Vorlaminate, welche als Schaltung Halbleiterchips, Antennen und gegebenenfalls weitere Schaltungselemente aufweisen. Die funktionellen Vorlaminate bestehen meist aus einer oder mehreren Substratfolien und zwei oder mehreren Deckfolien beidseitig der Substratfolie oder der Substratfolien. Die Folien bestehen meist aus thermoplastischen Materialien wie Polycarbonat (PC), Polyethylenterephthalat (PET), Polyvinylchlorid (PVC) und ähnlichen Kunststoffen.

Insbesondere zur Herstellung elektronischer Sicherheitskarten, die eine sehr lange Lebensdauer und eine sehr große Sicherheit gegen Manipulation aufweisen müssen, ist es erforderlich die Sicherheitskarten derart herzustellen, dass ein unbemerktes Herauslösen und Ändern des Chips unmöglich ist. Andererseits müssen die Sicherheitskarten eine große mechanische Stabilität besitzen, damit nach mindestens zehnjähriger Benutzung der Karten weder Risse noch Knicke noch ein Defekt an der elektronischen Schaltung auftreten. Des Weiteren muss die Sicherheitskarte oder Smart Card nach Lamination oder Verklebung des Substrates oder des Prelaminates mit weiteren Folien eine sehr hohe Qualität der glänzenden Kartenoberflächen garantieren.

Bevorzugtes Material für die Herstellung elektronischer Sicherheitskarten ist Polycarbonat. Polycarbonat weist eine große mechanische Stabilität auf und ist bis zu einer Temperatur von ca. 130°C temperaturbeständig. Ähnliche Qualitäten zeigt PET. Bei der Herstellung der Prelaminate wirken sich jedoch der große thermische Längenänderungskoeffizient und der starke Schrumpf der Materialien negativ auf die Qualität des Laminates aus. Dabei haben die Höhe der Bearbeitungstemperatur und deren Dauer einen Einfluss auf den tatsächlichen Schrumpf. Des Weiteren weist das Material einen relativ kleinen Erweichunasbereich (im Vergleich zu PVC) auf. Temperaturschwankungen beim Vorlaminieren führen zu signifikanten Differenzen der Viskosität und damit zum mehr oder minder starken Zufließen konstruktionsbedingter Durchbrüche in den Kernfolien bzw. der Substratfolie. Nach dem Vorlaminieren und/oder Endlaminieren wirken sich Schrumpf und Materialkontraktion so aus, dass erhebliche mechanische Spannungen um die elektronischen Module, die Schaltunasdrähte (Antennen) und an deren Verbindungsstellen auftreten, da die im Karteninneren befindlichen elektronischen Module und Antennendrähte nicht schrumpfen und sich beim Abkühlen nicht stark zusammenziehen. Damit verbunden sind mehrere sehr ungünstige Effekte:

Um die Module (Halbleiterchip, leadframe und Verguss) sind die mechanischen Spannungen im Polycarbonat so hoch, dass nach Biegebelastungen und/oder Temperaturwechseltests der Karten sich im umgebenden Polycarbonat Risse zeigen, die sich nach und nach über weitere Flächen der Karte ausbreiten. Andererseits bilden sich Modul und zum Teil auch der Schaltunasdraht (bei kontaktlosen Smart Cards der Antennendraht) deutlich auf der glänzenden Oberfläche der Sicherheitskarten ab. Die am Modul wirkenden mechanischen Spannungen üben zudem Scherwirkungen auf die Verbindungsstellen von Schaltunasdraht zu Modul aus und verringern die Zuverlässigkeit der Sicherheitskarten.

In DE 197 10 656 A1 ist eine Smart Card offenbart, wobei die Folien Ausnehmungen zur Aufnahme der Komponenten wie Antennenspule oder Chipmodul oder weitere elektronische Bauelemente haben. Die Komponenten werden in den Ausnehmungen in einen flüssigen Füllstoff eingelegt. Der überschüssige Füllstoff wird danach entfernt. Anschließend erfolgt das Härten des Füllstoffes und das Laminieren der Schichten.

In WO 2007/089140 A1 ist ein Identifikationsdokument angegeben, bei dem um den Chip herum ein gummiähnliches Material, welches einen höheren Ausdehnungskoeffizienten als die angrenzenden Laminatschichten aufweist, angeordnet ist.

In der US 2008/0179404 A1 werden ein Verfahren und eine Vorrichtung zur Herstellung von Transpondereinlagen beschrieben. Ein Transponderchipmodul ist in eine Oberfläche eines Substrates eingelassen. Endbereiche eines Antennendrahtes werden mittels eines Pflasters auf Anschlussbereichen des Chipmoduls gehalten, wobei das Pflaster transparent sein kann, um ein Verbinden des Antennendrahtes mit den Anschlussbereichen mittels Laser zu ermöglichen. Das Substrat sowie das darauf angeordnete Transponderchipmodul und der Antennendraht können von einer Abdeckung bedeckt sein. Zum Verbinden des Antennendrahtes mit den Anschlussbereichen kann ein Leitkleber oder ein Lötmaterial verwendet werden. Die Ausnehmung für das Chipmodul und ein Kanal für den Antennendraht können durch Laserabtragung im Substrat ausgeformt sein. Das Substrat kann Teslin^{™}, PET/PETE oder Polycarbonat sein. Der Antennendraht kann einen Durchmesser von 60 µm aufweisen. Unter dem Transponderchipmodul kann ein synthetisches Polstermaterial angeordnet sein.

Aus der US 6 665 931 B2 ist ein Verdrahtungsverfahren zum Aufbringen von Verbindungsdraht auf eine Substrattafel bekannt. Der Verbindungsdraht wird durch eine dreidimensionale Relativbewegung zwischen einem Verdrahtungskopf, welcher den Draht führt und dem Substrat auf dieses aufgebracht. Der Verdrahtungskopf bewegt sich entlang einer Klebeschicht auf der Oberfläche des Substrates. Der Verdrahtunaskopf und die Klebeschicht nähern sich für eine Punktkontaktierung periodisch an.

In der DE 196 19 771 A 1 werden ein Verfahren und eine Vorrichtung zur Verlegung eines Drahtleiters auf einem Substrat sowie hiermit hergestellte Substrate beschrieben. Ein drahtförmiger Leiter wird auf einem Substrat mittels einer mit Ultraschall auf den Drahtleiter einwirkenden Verleevorrichtung verlegt, wobei der Drahtleiter in einer Richtung quer zur Verlegebene mit Ultraschall beaufschlagt wird und die durch die Ultraschallbeaufschlagung erzeugte Querbewegung der Verlegevonichtung der in der Verlegeebene verlaufenden Verlegebewegung überlagert wird.

Aus der DE 44 10 732 A 1 sind ein Verfahren zur Herstellung einer Chipkarte sowie eine Chipkarte bekannt. Im Verfahren zur Herstellung einer zumindest einen Chip und eine Spule aufweisenden Transpondereinheit, insbesondere einer Chipkarte werden der Chip und die Spule auf einem gemeinsamen Substrat angeordnet und die Ausbildung der Spule erfolgt durch Verlegung eines Spulendrahts sowie die Verbindung von Spulendrahtenden mit Anschlussflächen des Chips auf dem Substrat.

In der DE 198 40 220 A 1 werden ein Transpondermodul und ein Verfahren zur Herstellung desselben beschrieben. Ein Transpondermodul, insbesondere für ein elektronisches Etikett, umfasst eine aus einem isolierenden Material bestehende Schicht, die als einziges Trägersubstrat vorgesehen ist. Auf einer ersten Hauptoberfläche des Trägersubstrats ist eine Antenneneinrichtung gebildet. In einer Ausnehmung des Trägersubstrats ist ein ungehäuster Schaltungschip derart angeordnet, dass eine erste Hauptoberfläche des Schaltungschips im Wesentlichen bündig zu der ersten Hauptoberfläche des ersten Trägersubstrats ist. Elektrische Verbindungseinrichtungen zwischen dem Schaltungschip und der Antenneneinrichtung sind vorgesehen. Dieses Transpondermodul weist eine extrem geringe Dicke auf. Eine Mehrzahl von Verfahren kann verwendet werden, um ein derartiges Transpondermodul herzustellen.

Aus der DE 199 20 593 B4 und aus der DE 199 20 593 A1 sind ein Chipträger für ein Chipmodul und ein Verfahren zur Herstellung des Chipmoduls bekannt. Ein Chipträger zur Ausbildung eines Chipmoduls weist ein Substrat und auf dem Substrat angeordnete Anschlussleiter auf. Die Anschlussleiter sind streifenförmig ausgebildet und erstrecken sich parallel zueinander über das Substrat. Die Anschlussleiter bestehen aus auf das Substrat aufgebrachten elektrisch leitfähigen, in ihrer Ausbildung vom Substrat unabhängigen Anschlussbändern. Das Substrat ist durch eine Trägerfolie gebildet. Die Anschlussbänder sind zumindest abschnittsweise mit einem Verbindungsmaterialauftrag zur Kontaktierung mit Kontaktmetallisierungen eines Chips versehen.

In der DE 41 15 421 A1 wird ein System zum verbindungskontaktlosen, automatisierten Bandbonden beschrieben. Eine Vorrichtung zum Erzeugen einer Schnittstelle zu einem Gerät, das eine Mehrzahl von eng beabstandeten Leitern hat, weist eine erste dielektrische Einrichtung zur Isolierung mit einer ersten Seite und einer zweiten Seite und eine erste Signalleitereinrichtung zur elektrischen Kopplung auf, die mit der ersten Seite der dielektrischen Einrichtung verbunden ist. Des Weiteren weist die Vorrichtung eine erste Signalinterferenzenminimierungseinrichtung zur Reduzierung von elektrischen Interferenzen auf, die an die zweite Seite der ersten dielektrischen Einrichtung gekoppelt ist. Die erste Signalinterferenzenminimierungseinrichtung enthält einen ersten Signalminimierungsleiter zur elektrischen Kopplung, der nicht durch die erste dielektrische Einrichtung hindurchgeht.

Aus der DE 6 608 316 U ist eine Anordnung zum Verschweißen von mit Isolation versehenen Teilen mittels Schweißelektroden bekannt. Zumindest eine der Elektroden ist mit einer vom Schweißaggregat unabhängigen Heizvorrichtung versehen.

In der US 2008/0143534 A1 werden eine Vorrichtung und ein Verfahren zum Herstellen einer Antenne für eine Funkfrequenzidentifizierungseinheit beschrieben. Die Vorrichtung zur Herstellung einer Antenne für Drahttransponder aus elektrische leitendem Material umfasst zumindest eine Ablegeeinheit zum Ablegen des Drahtes auf dem Substrat, welches auf einem Halteelement platziert ist. Die Ablegeeinheit und das Substrat sind relativ zueinander bewegbar. Das Halteelement ist parallel zu zumindest zwei Achsen eines kartesischen Koordinatensystems bewegbar. In einem Verfahren zur Herstellung der Antenne wird eine Schicht oder ein Draht aus elektrisch leitendem Material von zumindest einer Rolle abgerollt und auf eine Oberfläche eines Substrates mittels zumindest eines Presselementes aufgepresst, befestigt und die befestigte Schicht bzw. der befestigte Draht von der Schicht bzw. dem Draht auf der Rolle mittels zumindest einer Schneideeinheit abgetrennt. Das Substrat ist relativ zu der Anordnung, welche die Rolle, das Presselement und Schneideeinheit umfasst, parallel zu zumindest einer Achse eines kartesischen Koordinatensystems beweglich.

Aus der US 6,111,303 A sind eine kontaktlose elektronische Karte und ein Verfahren zur Herstellung einer solchen Karte bekannt. Die elektronische Karte umfasst einen elektrisch isolierenden Kartenträger, der mindestens eine Spule aufnimmt, welche als Antenne dient, und eine integrierte Schaltung, die elektrisch mit den Enden der Spule verbunden ist. Der Kartenträger weist auf einer strukturierten Seite eine Senkung auf, an deren Wänden und Boden die Wicklungen der Spule verlaufen, die zudem auch auf der strukturierten Fläche verlaufen. Die Senkung enthält auch die Enden der Spule und die integrierte Schaltung. Die Senkung ist außerdem mit einem polymerisierten Schutzharz gefüllt. Eine Folie aus Isoliermaterial deckt die strukturierte Fläche ab.

In der US 2003/0085454 A1 werden eine Chipkarte und ein Herstellungsverfahren beschrieben. Die Chipkarte mit einer Mehrzahl von aneinander liegenden und durch Wärme und Druck miteinander verbundenen Kartenschichten weist eine innere Trägerschicht und an einer Oberseite derselben eine Antennenspule mit einer Mehrzahl von Leiterbahnen und an den Enden derselben angeordnete Spulenpads einerseits und eine Ausnehmung zur Aufnahme eines Chipmoduls andererseits auf. Die Spulenpads sind in einem Kontaktierungsbereich zu beiden Seiten eines durch die nebeneinander verlaufenden Leiterbahnen gebildeten Leiterbahnabschnitts angeordnet, wobei die Ausnehmung in dem Leiterbahnabschnitt angeordnet ist, derart, dass das Chipmodul unter direkter Anlage von Chipanschlüssen desselben an den Spulenpads der Antennenspule in die Ausnehmung einsetzbar ist.

Aus der EP 0 689 164 A2 sind ein Verfahren zur Herstellung von Datenträgern bekannt. Die Datenträger aus einem Mehrnutzenbogen enthalten auf mindestens einer ihrer Oberflächen ein positioniertes Element. Hierbei werden möglichst viele Verfahrensschritte am Mehrnutzenbogen durchgerührt, der vor der Positionierung der Elemente in den Datenträgern in kleinere Einheiten unterteilt wird, die über Positionierungsmarkierungen verfügen. Anhand der Markierungen werden die kleinen Einheiten in eine genaue Position zu verschiedenen Verarbeitungsstationen gebracht, wo mehrere Datenträger in den Einheiten gleichzeitig mit einem positionierten Element versehen werden.

In der DE 198 55 023 A1 werden ein Verfahren und eine Vorrichtung zum Aufbringen einer flexiblen Leiterbahn auf eine beliebig geformte Oberfläche beschrieben. Die Leiterbahn wird wenigstens an einer Stelle an der Oberfläche fixiert und geradlinig bis zu einem Bereich an der Oberfläche aufgebracht, an dem der Leiterbahnverlauf eine Richtungsänderung erfährt. Unmittelbar vor der Richtungsänderung des Leiterbahnverlaufs wird an wenigstens einer zweiten Stelle die Leiterbahn gegen die Oberfläche zumindest zeitweise fixiert. Die Leiterbahn wird unter Zugspannung und in einer neuen geradlinig verlaufenden Richtung auf die Oberfläche aufgebracht. Die Leiterbahn wird im Bereich der Richtungsänderung mit Hilfe eines Anpresswerkzeuges bündig gegen die Oberfläche gedrückt. Die Fixierung der Leiterbahn gegen die Oberfläche bleibt zumindest an der zweiten Stelle wenigstens solange erhalten, bis die weitere Verlegung der Leiterbahn an eine Stelle einer weiteren Richtungsänderung kommt, an der die Leiterbahn wieder fixiert wird, oder an einen Endpunkt der Leiterbahn gelangt.

Eine weitere Methode ist, das Volumen der Leiterdrähte und des Modules zu verringern und somit die mechanischen Spannungen im Polycarbonat zu vermindern. Als Antenne werden gedruckte Leiterbahnen verwendet, auf die der Chip mittels flip chip-Bondmethode direkt gebondet ist. Kostentreibend ist der hohe Silberpreis der Druckpaste und die erforderliche Aushärtungstemperatur und -zeit der Druckpaste, die wiederum zu einem Schrumpf der gedruckten Folie führt. Um den Chip beim Vorlaminieren zu schützen, ist auf die bestückte Substratfolie eine weitere Folie zu laminieren, die Durchbrüche für die Aufnahme des bereits gebondeten Chips aufweist. Um Scherspannungen zwischen Substratfolie und Schutzfolie beim Vorlaminieren durch unterschiedliches Schrumpfen zu vermeiden, muss auch die Schutzfolie zuvor etwa die gleiche Temperaturbehandlung wie die bedruckte Substratfolie erfahren; die Scherspannungen können zudem zur Verbiegung der Vorlaminate führen.

Der Erfindung liegt die Aufgabe zu Grunde, ein verbessertes Verfahren zur Erzeugung eines Schaltungsmusters auf einem Substrat und eine verbesserte Vorrichtung zur Erzeugung eines Schaltungsmusters auf einem Substrat anzugeben.

Die Aufgabe wird erfindungsgemäß gelöst durch ein Verfahren zur Erzeugung eines Schaltungsmusters auf einem Substrat mit den Merkmalen des Anspruchs 1 und eine Vorrichtung zur Erzeugung eines Schaltungsmusters auf einem Substrat mit den Merkmalen des Anspruchs 9.

Vorteilhafte Ausgestaltungen der Erfindung sind Gegenstand der Unteransprüche.

Eine Schaltungsanordnung umfasst ein Substrat mit zumindest einem elektronischen Bauelement. Auf und/oder in dem Substrat ist zumindest ein metallisches, elektrisch leitendes Leiterband verdrillungsfrei in einem Schaltungsmuster angeordnet, wobei Anschlüsse des elektronischen Bauelements mit Kontaktierbereichen des Leiterbandes elektrisch verbunden sind.

Unter dem Begriff Leiterband ist ein bandförmig ausgeformter elektrischer Leiter zu verstehen, dessen Breite mindestens das Vierfache seiner Dicke beträgt.

Bevorzugt beträgt die Breite des Leiterbandes das Zehnfache bis das Hundertfache seiner Dicke.

Damit hat das Leiterband bei vergleichbarer Leistungsfähigkeit eine wesentlich geringere Dicke als Draht gleichen Querschnittes und lässt sich gut auf dem Substrat anbringen oder gut in das Substrat einbetten. Das Leiterband lässt sich gut kontaktieren und verkleben. Das Leiterband weist in Richtung einer Dicke einer künftigen Karte nur eine sehr geringe Höhe auf, die sich positiv auf ein Kartendesign auswirkt.

Die Schaltungsanordnung eignet sich insbesondere für die Herstellung von Sicherheitsdokumenten wie beispielsweise Smart Cards, Kreditkarten, elektronischen Personalausweisen oder elektronischen Gesundheitskarten und ist auf einfache, kostengünstige und hoch produktive Weise herstellbar. Die Schaltungsanordnung weist eine sehr geringe Dicke von kleiner 0,4 mm auf, ist mechanisch spannungsarm, ist durch Verkleben oder Laminieren weiter verarbeitbar und ermöglicht so eine hohe Designqualität eines Endlaminates. Insbesondere durch ein vollständiges Einbetten des Leiterbandes in das Substrat weisen eine Leiterbandoberfläche und eine Substratoberfläche nahezu ein gleiches Niveau auf. Dadurch ergeben sich bei nachfolgenden Verarbeitungsschritten bessere Verklebe- oder Laminierergebnisse. Es sind komplexe Schaltungen in Sicherheitskarten, Smart Cards und ähnlichen oder vergleichbaren Anwendungen herstellbar unter Verwendung verschiedener Materialien, beispielsweise Polycarbonat (PC) oder andere Thermoplasten oder synthetische Papiere, Gewebe (sehr dicht oder sehr dünn und eben), Metalle oder Holz als Substrat.

Durch ein Verlegen und Einbetten von Leiterband ergeben sich folgende Vorteile: Für die Kontaktierung der elektronischen Bauelemente stehen flache, breite und ebene Kontaktierbereiche zur Verfügung. Die Leiterbänder haben eine wesentlich geringere Dicke als Draht gleichen Querschnittes und sie lassen sich gut auf dem Substrat anbringen oder gut in das Substrat einbetten. Leiterbänder lassen sich gut kontaktieren und verkleben. Die Leiterbänder weisen in Richtung der Dicke der künftigen Karte nur eine sehr geringe Höhe auf, die sich positiv auf ein Kartendesign auswirkt. Die Leiterbänder selbst können Sicherheitsmerkmale tragen.

Aufgrund der größeren Oberfläche des Leiterbandes in Relation zum Leiterdraht gleichen Querschnittes eignet sich Leiterband sehr gut für Anwendungen im Ultrahochfrequenzbereich, da, bedingt durch einen Skineffekt, in Bereichen sehr hoher Frequenz ein elektrischer Widerstand von Drahtleitern erheblich ist. Des Weiteren ist durch die breiten Leiterbänder eine aktive Oberfläche des an die Leiterbänder kontaktierten Halbleiterchips optisch sehr stark abgeschattet.

Elektronische Bauelemente, welche auf dem Substrat angeordnet sein können, sind beispielsweise Halbleiterchips, deren Anschlüsse Kontakthügel und/oder Feindrähte sein können, Module (Halbleiterchip auf einem Chipträger mit vergrößerten Kontakten und Plastumhüllung zum Schutz des Chips und der Mikrokontaktierung), Resistore, Kondensatoren, Dioden, Kurzschlussstücke, Schalter und dergleichen. Die Halbleiterchips weisen vorteilhaft als Anschlussstellen Anschlusshügel auf, wobei je nach Kontaktiemngsverfahren die Anschlusshügel (bump) aus Gold, aus Nickel, aus Kupfer mit Nickelüberzug, aus Kupfer oder Nickel mit Lotüberzug, aus Palladium, ausgehärtetem Leitkleber oder anderen Materialien bestehen können. Das Schaltungsmuster besteht aus mindestens einem Leiterbandzug, der entsprechend der zu realisierenden Schaltung beliebig viele kreisbogenförmige Richtungsänderungen aufweist. Der Kontaktierbereich ist nur dasjenige anteilige elektrische isolierte oder entisolierte Flächenstück des Leiterbandes, auf welchem eine Kontaktgabe mit einem Anschluss des elektronischen Bauelementes oder mit einem weiteren Leiterbandzug erfolgen wird. Andere Bereiche des Leiterbandes sind isoliert, um eventuelle Kurzschlüsse mit Chipkanten o.ä. zu vermeiden.

Leiterband kann auf lediglich einer Oberflächenseite oder auch auf beiden Oberflächenseiten des Substrats angeordnet und/oder in die jeweilige Oberflächenseite eingebettet sein. Dadurch sind eine oder mehrere Schaltungsanordnungen auf dem Substrat erzeugbar, welche miteinander kontaktiert oder unabhängig voneinander sind.

In einer vorteilhaften Ausführungsform ist das elektronische Bauelement auf einer Oberflächenseite des Substrates angeordnet. Bevorzugt weist das Substrat zumindest einen Durchbruch auf. In diesem Durchbruch ist in einer weiteren Ausführungsform das elektronische Bauteil angeordnet. Zweckmäßigerweise überspannt zumindest das eine Leiterband den Durchbruch, so dass das Bauteil mit dem Leiterband oder mit mehreren, den Durchbruch überspannenden Leiterbändern kontaktiert ist. In einer weiteren bevorzugten Ausführungsform sind auf beiden Oberflächenseiten des Substrates Leiterbänder angeordnet und überspannen den Durchbruch im Substrat, wobei Kontaktierbereiche der Leiterbänder durch den Durchbruch elektrisch miteinander verbunden sind. Die Leiterbänder sind beispielsweise durch den Durchbruch hindurch miteinander verschweißt und auf diese Weise miteinander kontaktiert.

In einer weiteren vorteilhaften Ausführungsform sind die Leiterbänder über ein im Durchbruch angeordnetes Metallstück elektrisch miteinander verbunden. Ist in dem Durchbruch ein elektronisches Bauelement angeordnet, so ist dieses mit Schaltungsmustern auf beiden Seiten des Substrates elektrisch kontaktierbar.

Die Leiterbänder können des Weiteren auch auf beiden Oberflächenseiten des Substrats angeordnet sein, ohne durch den Durchbruch miteinander elektrisch verbunden zu sein. Sie können dabei auch einen Durchbruch lediglich überspannen und nicht über diesen elektrisch miteinander kontaktiert sein. Durch die Leiterbänder auf beiden Oberflächenseiten, welche miteinander elektrisch kontaktiert sein können oder auch nicht, sind auf beiden Seiten des Substrates Schaltungsmuster erzeugbar.

Zweckmäßigerweise ist das Substrat aus einem thermoplastischen Material, so dass es beispielsweise mittels eines thermischen oder ultraschallunterstützten Verfahrens zumindest teilweise aufschmelzbar ist und das Leiterband in das Substrat einbettbar ist.

Zweckmäßigerweise ist das Leiterband aus Kupfer oder aus einer Kupferlegierung und weist vorzugsweise eine hohe Duktilität auf. Kupfer und Kupferlegierungen stellen eine hohe elektrische Leitfähigkeit, eine hohe Duktilität und gute Löt- und Schweißeigenschaften sicher. Durch die hohe Duktilität ist das Leiterband gut verformbar und somit gut auf dem Substrat verlegbar.

Bevorzugt weist das Leiterband eine bis zu 3 µm dicke Oberflächenschicht aus einem Edelmetall auf, insbesondere aus Silber. Dadurch ist eine verbesserte Kontaktqualität mit den elektronischen Bauelementen erzielbar.

In einer vorteilhaften Ausführungsform weist das Leiterband zumindest auf einer Oberflächenseite zumindest über einen Teil seiner Länge eine musterartige Prägung auf. Diese Prägung kann einerseits eine Verbindung von Leiterband und Substrat oder eine elektrische Kontaktierung des Bauelements verbessern und andererseits als Sicherheitsmerkmal dienen.

Vorzugsweise ist das Leiterband zumindest auf einer dem Substrat zugewandten Oberflächenseite mit einem aufschmelzbaren Isolierlack beschichtet, welcher zweckmäßigerweise eine bis zu Temperaturen von 190°C bis 350°C hitzebeständige Kernlackschicht und eine bei Temperaturen ab 130°C aufschmelzbare Backlackschicht umfasst. Während eines Verlegens des Leiterbandes auf das Substrat ist die Backlackschicht aufschmelzbar und somit das Leiterband fest an das Substrat anbindbar. Soll das im oder auf dem Substrat befestigte Leiterband auf einer Flächenseite metallische Oberflächen aufweisen, ist es vorteilhaft, wenn das Leiterband nur auf der dem Substrat zugewandten Oberflächenseite Isolierlack aufweist. Eine Beschichtung nur einer Oberflächenseite des Leiterbandes mit Isolierlack kann auch aus Gründen einer Dickenreduzierung oder einer Designqualitätsverbesserung vorteilhaft sein. Zweckmäßigerweise ist zumindest auf einer Oberflächenseite des Substrates eine erste Deckfolie angeordnet, bevorzugt aus einem thermoplastischen Material. Diese erste Deckfolie überspannt vorteilhafterweise zumindest den Durchbruch im Substrat und ist durch Lamination und/oder Verklebung mit dem Substrat zumindest in einem Umgebungsbereich des Durchbruchs verbunden. Die erste Deckfolie ist mit dem Substrat beispielsweise durch einen zeitlich sehr kurzen Laminieiprozesses mittels Druck und Wärme oder Druck und Ultraschallenenergie verbindbar. Somit ist das elektronische Bauelement abgedeckt und geschützt. Die Deckfolie kann ebenfalls beispielsweise aus Papier, papierähnlichen Materialien oder Gewebe bestehen.

Es ist weiterhin von Vorteil, wenn auf der zweiten Oberflächenseite der Substratfolie zumindest im Bereich des Durchbruches und des Umgebungsbereiches ebenfalls die erste Deckfolie, bevorzugt eine thermoplastische Deckfolie, aufgebracht und durch Lamination mittels Druck und Wärme mit der Substratfolie verbunden ist, so dass das elektronische Bauelement und die Schaltung optimal geschützt sind. Durch die Deckfolien ist um das Bauelement herum in dem Durchbruch eine Kavität gebildet, welche mittels Vergussmasse oder Klebstoff ausgefüllt ist, wodurch das Bauteil sicher gealtert und geschützt ist. Mit einem Boden der Kavität fest verbunden und in einer definierten Flachlage befindet sich mindestens ein Leiterbandabschnitt mit einer in Bezug zur weiteren Schaltung definiert entisolierten Kontaktierstelle. Durch die breiten Leiterbänder ergibt sich eine sehr starke optische Abschattung der aktiven Oberfläche des kontaktierten Halbleiterchips.

In einer vorteilhaften Ausführungsform ist zwischen der ersten Deckfolie und dem Substrat eine zweite Deckfolie angeordnet, welche zweckmäßigerweise aus einem thermoplastischen Material ist. Die zweite Deckfolie weist zweckmäßigerweise zumindest eine Aussparung zur Einbettung des elektronischen Bauelementes auf. Die erste Deckfolie überspannt zweckmäßigerweise zumindest die Aussparung in der zweiten Deckfolie. Die zweite Deckfolie ist vorzugsweise mit dem Substrat und/oder mit der ersten Deckfolie durch Lamination und/oder Verklebung verbunden. Dadurch ist das Bauelement auf dem Substrat anordbar und ist von der zweiten Deckfolie umgeben. Von der ersten Deckfolie ist es abgedeckt und somit geschützt. Durch die erste Deckfolie ist die Aussparung fest verschlossen, wodurch sich eine definierte Kavität zur Aufnahme des elektronischen Bauelementes bildet. Mit dem Boden der Kavität fest verbunden und in einer definierten Flachlage befindet sich mindestens ein Leiterbandabschnitt mit einer in Bezug zur weiteren Schaltung definiert entisolierten Kontaktierstelle. Durch die breiten Leiterbänder ergibt sich eine sehr starke optische Abschattung der aktiven Oberfläche des kontaktierten Halbleiterchips.

Vorzugsweise ist das elektronische Bauelement zur Isolierung und/oder Befestigung am Substrat, an zumindest einem Leiterband und/oder an zumindest einer Deckfolie zumindest bereichsweise von einer Vergussmasse und/oder von einem Klebstoff umschlossen. Damit ergeben sich folgende Vorteile: Mittels eines der üblichen kostengünstigen flip chip- Kontaktierungsverfahren ist das Bauteil auf den sehr kostengünstig hergestellten flachen und metallischen Leiterbandabschnitten beispielsweise in der Kavität platziert und das Restvolumen der Kavität mit härtbarem Kleber verfüllt. Das Bauelement ist durch den auf den Leiterbandabschnitten außerhalb der Kontaktierbereiche noch vorhandenen Isolierlack und durch nachgeflossene Vergussmasse vor Kantenschlüssen mit anderen Bereichen der Leiterbänder geschützt. Das Bauelement und die Kontaktierung befinden sich vollständig in der Kavität. Das Bauelement befindet sich zentrisch in dem Durchbruch der Substratfolie. Diese Lage schützt das Bauelement vor sonst möglicherweise auftretenden unsymmetrischen mechanischen Belastungen.

Die Schaltungsanordnung ermöglicht ein schichtsymmetrisches Vorlaminat mit in eine oder mehrere Kavitäten eingebrachten, kontaktierten und in Vergussmassen oder Klebstoff eingebetteten elektronischen Bauelementen. Sind als Bauelemente Halbleiterchips mittels Kleben flip chip-kontaktiert, kann die sonst übliche Aushärtung des Klebstoffs mittels einzeln auf die Chips aufgesetzten Thermoden insofern entfallen, so dass die geringfügig über die Kavität herausstehenden Chips über die aufgelegte Deckfolie beim Laminieren in Richtung Leiterbandabschnitte pressbar und in dieser Stellung durch den härtenden Klebstoff bzw. die Vergussmasse fixierbar sind. Kontaktieren und Laminieren sind in einem Schritt bei geringster möglicher Temperaturbelastung der Substratfolie und unter Vermeidung von Schubwirkungen der Substrat- und Deckfolien auf die elektronischen Bauelemente und deren Kontaktierung mit den Leiterbändern möglich. Dadurch sind kosten- und justageaufwändige Thermodenanordnungen vermeidbar.

Die Schaltungsanordnung und deren Ausführungsformen ermöglichen die Herstellung von kontaktlosen Chipkarten, von komplexen Chipkarten und von einfachen elektrischen Schaltungen unter Verwendung des breiten Leiterbandes. Dadurch sind sehr ebene, flache und sehr zuverlässige Schaltungen herstellbar, welche dünnen, ein- oder beidseitig mit Leiterbahnen versehenen Leiterplatten ähneln, diesen gegenüber jedoch die Vorteile einer sehr flexiblen Herstellung, einfach herzustellender elektrisch isolierter Leiterkreuzungen und eine Überquerung von Durchbrüchen aufweisen. Dies ist bei Leiterplatten nicht oder nur mit einem sehr hohen Aufwand möglich. Des Weiteren sind definierte Kavitäten mit am Kavitätsboden befestigten Leiterbändern herstellbar. Die Kavitäten oder Durchbrüche im Substrat sind mit dem breiten Leiterband sehr einfach überspannbar.

Das breite Leiterband ermöglicht zudem sehr breite Kontaktierflächen, die eine sichere Flip-Chip-Kontaktierung ermöglichen und Laser- oder Thermokompressionskontaktierungen erleichtern, da ebene und dünne Metallflächen den Energieeintrag und die Energieleitung vereinfachen und präziser steuern lassen als die im Stand der Technik verwendeten Runddrähte oder verdrillten Rechteckdrähte. Des Weiteren ist durch die breiten Leiterbänder eine aktive Oberfläche des an die Leiterbänder kontaktierten Halbleiterchips optisch sehr stark abgeschattet.

In einem Verfahren zur Erzeugung eines Schaltungsmusters auf einem Substrat wird auf zumindest eine Oberflächenseite des Substrates zumindest ein Leiterband verdrillungsfrei aufgebracht, wobei eine Leiterbandspule verwendet wird, die um eine horizontale Drehachse drehbar gelagert in einer Spulenaufnahme angeordnet ist, welche um eine vertikale Drehachse drehbar gelagert ist, wobei die Spulenaufnahme mittels einer Nachführeinrichtung bei Richtungsänderungen während eines Verlegens des Leiterbandes auf dem Substrat derart nachgedreht wird, dass das Leiterband verdrillungsfrei tangential von der Leiterbandspule abgespult wird

Erfindungsgemäß ist das zumindest eine Leiterband, welches auf zumindest eine Oberflächenseite des Substrates verdrillungsfrei aufgebracht wird, zumindest auf einer dem Substrat zugewandten Oberflächenseite mit einem aufschmelzbaren Isolierlack beschichtet, wobei der Isolierlack mittels Ultraschall erwärmt und zumindest teilweise aufgeschmolzen wird und das Leiterband verdrillungsfrei auf das Substrat aufgepresst wird. Die Ultraschallfrequenz kann 40 kHz bis 140 kHz betragen. Das Leiterband wird erfindungsgemäß mittels eines zylinderförmigen oder konischen ultraschallangeregten Verlegewerkzeugs verlegt, welches zumindest über einen Teil seiner Länge eine das Leiterband führende Innenbohrung und eine ringförmige, in Innen- und Außenradius übergehende, senkrecht zu seiner Längsachse angeordnete Wirkfläche aufweist. Erfindungsgemäß wird mittels einer zwischen einer Umlenkrolle und der Leiterbandspule angeordneten vertikal beweglichen weiteren Umlenkrolle mit einem Dämpfungsgewicht eine Leiterbandreserveschleife erzeugt. Die erste erwähnte Umlenkrolle ist an einer mit der Spulenaufnahme fest verbundenen Halterung angeordnet.

Durch die Leiterbandreserveschleife wird ein gleichmäßiges ruckfreies Verlegen des Leiterbandes sichergestellt. Durch die vertikal bewegliche Umlenkrolle mit Dämpfungsgewicht wird ein gleichmäßiges Abspulen des Leiterbandes und eine hohe Verlegegeschwindigkeit bei geringer Zugkraft auf das Leiterband sichergestellt. Durch die Leiterbandreserveschleife kann die Leiterbandabwicklung von der Leiterbandspule weitgehend kontinuierlich erfolgen, so dass die Leiterbandspule nicht ständig angerollt und wieder gestoppt werden muss. Durch die beschriebene Vorgehensweise erfolgt eine verdrillungsfreie Leiterbandzuführung zum Verlegewerkzeug, wird eine vorgebbare und geringe Leiterbandvorspannung erhalten und das Leiterband wird von der Leiterbandspule auch bei Verlegegeschwindigkeiten im Bereich von 10 cm/s bis 100 cm/s und starken Geschwindigkeitsänderungen (enge Radien; Mäandermuster) im Wesentlichen kontinuierlich abgespult. Es wird vermieden, dass Leiterband beim Abspulen längs zu dehnen und damit seine Geometrie, seine Festigkeit und seine elektrischen Kennwerte zu verändern.

Vorteilhafterweise weist das Leiterband eine Dicke von mindestens 5 µm auf.

Vorzugsweise weist das Leiterband eine Breite von 0,2 mm bis 1 mm, besonders bevorzugt 0,25 mm bis 1 mm und eine Dicke von 10 µm bis 50 µm auf

Das Leiterband wird auf das Substrat gerade oder kreisbogenförmig in vorgegebenen Radien und knickfrei aufgebracht.

Damit hat das Leiterband bei vergleichbarer Leistungsfähigkeit eine wesentlich geringere Dicke als Draht gleichen Querschnittes und lässt sich gut auf dem Substrat anbringen oder gut in das Substrat einbetten. Das Leiterband lässt sich gut kontaktieren und verkleben. Das Leiterband weist in Richtung einer Dicke einer künftigen Karte nur eine sehr geringe Höhe auf, die sich positiv auf ein Kartendesign auswirkt.

Durch das kurzzeitige Aufschmelzen infolge einer Energiezufuhr durch Ultraschallschwingungen oder durch Zufuhr von Wärmeenergie durch Laserlicht oder Erwärmung durch ein beheiztes Legewerkzeug oder durch Anlösen einer Backlackschicht des Isolierlacks durch ein geeignetes Lösungsmittel wird die Backlackschicht kurzzeitig erweicht, so dass sie eine Klebeverbindung mit der darunter liegenden Substratfläche eingeht, um anschließend durch Abkühlung oder durch Verdampfen des Lösungsmittels wieder in den festen Zustand zurückzukehren. Dadurch wird auf dem Substrat ein Schaltungsmuster erzeugt und das Leiterband optimal auf dem Substrat befestigt.

Durch ein Verlegen und Einbetten von Leiterband ergeben sich folgende Vorteile: Für die Kontaktierung von elektronischen Bauelementen stehen flache, breite und ebene Kontaktierbereiche zur Verfügung. Die Leiterbänder haben eine wesentlich geringere Dicke als Draht gleichen Querschnittes und sie lassen sich gut auf dem Substrat anbringen oder gut in das Substrat einbetten. Leiterbänder lassen sich gut kontaktieren und verkleben. Die Leiterbänder weisen in Richtung der Dicke der künftigen Karte nur eine sehr geringe Höhe auf, die sich positiv auf ein Kartendesign auswirkt. Die Leiterbänder selbst können Sicherheitsmerkmale tragen.

Aufgrund der größeren Oberfläche des Leiterbandes in Relation zum Leiterdraht gleichen Querschnittes eignet sich Leiterband sehr gut für Anwendungen im Ultrahochfrequenzbereich, da, bedingt durch einen Skineffekt, in Bereichen sehr hoher Frequenz ein elektrischer Widerstand von Drahtleitern erheblich ist. Des Weiteren ist durch die breiten Leiterbänder eine aktive Oberfläche des an die Leiterbänder kontaktierten Halbleiterchips optisch sehr stark abgeschattet.

Elektronische Bauelemente, welche auf dem Substrat angeordnet sein können, sind beispielsweise Halbleiterchips, deren Anschlüsse Kontakthügel und/oder Feindrähte sein können, Module (Halbleiterchip auf einem Chipträger mit vergrößerten Kontakten und Plastumhüllung zum Schutz des Chips und der Mikrokontaktierung), Resistore, Kondensatoren, Dioden, Kurzschlussstücke, Schalter und dergleichen. Die Halbleiterchips weisen vorteilhaft als Anschlussstellen Anschlusshügel auf, wobei je nach Kontaktierungsverfahren die Anschlusshügel (bump) aus Gold, aus Nickel, aus Kupfer mit Nickelüberzug, aus Kupfer oder Nickel mit Lotüberzug, aus Palladium, ausgehärtetem Leitkleber oder anderen Materialien bestehen können. Das Schaltungsmuster besteht aus mindestens einem Leiterbandzug, der entsprechend der zu realisierenden Schaltung beliebig viele kreisbogenförmige Richtungsänderungen aufweist. Der Kontaktierbereich ist nur dasjenige anteilige elektrisch isolierte oder entisolierte Flächenstück des Leiterbandes, auf welchem eine Kontaktgabe mit einem Anschluss des elektronischen Bauelementes oder mit einem weiteren Leiterbandzug erfolgen wird. Andere Bereiche des Leiterbandes sind isoliert, um eventuelle Kurzschlüsse mit Chipkanten o.ä. zu vermeiden.

In einer vorteilhaften Ausführungsform wird das Substrat vor dem Aufbringen des Leiterbandes zumindest in einem Bereich des zu erzeugenden Schaltungsmusters vorgewärmt. Dies ist besonders vorteilhaft bei thermoplastischen Substraten mit hohen Erweichungs- oder Schmelzpunkten (z.B. Polycarbonat) und bei Substraten aus Metallen oder ähnlichen Materialien. Dadurch wird ein notwendiger Energieeintrag, welcher durch ein Verlegewerkzeug zu erzeugen ist, reduziert und eine Verlegeproduktivität wird gesteigert.

In einer vorteilhaften Ausführungsform wird eine Oberfläche des Substrates durch thermische Energie oder mittels Ultraschall erwärmt und zumindest teilweise aufgeschmolzen und das Leiterband unter Verdrängung und/oder Verdichtung eines Materials des Substrates zumindest teilweise in das Substrat hineingepresst. Dadurch weisen die Leiterbandoberfläche und die Substratoberfläche nahezu ein gleiches Niveau auf, wodurch sich bei nachfolgenden Verarbeitungsschritten bessere Verklebe- oder Laminierergebnisse ergeben. Vorteilhaft ist als Verlegeverfahren das Verlegen des Leiterbandes mittels Ultraschallunterstützung anzuwenden. Thermisch unterstützte Verlegeverfahren benötigen für ein störungsfreies Verlegen mindestens einseitig nichtisolierte Leiterbänder. Das Verlegen von Leiterbändern durch Ankleben des angelösten Isolierlacks ist nicht produktiv, und es treten Lösungsmittelemissionen auf.

Zweckmäßigerweise wird das Verlegewerkzeug relativ zum Substrat und/oder das Substrat relativ zum Verlegewerkzeug bewegt. Das Verlegewerkzeug führt auf dem Substrat Relativbewegungen in der Substratebene aus, die exakt das zu erzeugende Schaltungsmuster darstellen. Die Relativbewegung kann durch Bewegen des Verlegewerkzeuges auf dem Substrat, durch Verfahren des Substrates unter dem aufgesetzten Verlegewerkzeug oder durch Bewegung des Verlegewerkzeuges und des Substrates erfolgen. Die Bewegung des Verlegewerkzeugs und/oder des Substrats, um die Relativbewegung zu erzeugen, kann insbesondere in x-Richtung und/oder in y-Richtung eines dreidimensionalen Koordinatensystems erfolgen. Eine Bewegung in z-Richtung kann beispielsweise zum Aufsetzen des Verlegewerkzeugs auf das Substrat erfolgen. Die x-Richtung und die y-Richtung des dreidimensionalen Koordinatensystems spannen eine horizontale Ebene auf, die x-Richtung und die y-Richtung spannen mit der z-Richtung des dreidimensionalen Koordinatensystems jeweils eine vertikale Ebene auf.

Eine Drehung des Substrates und/oder des Verlegewerkzeugs um eine Drehachse senkrecht zur Substratoberfläche ist möglich, wobei die Drehung des Verlegewerkzeugs auch vorteilhaft ist. Die Drehung des Substrates ist jedoch nicht sehr sinnvoll, insbesondere nicht bei einer Mehrzahl parallel angeordneter Verlegewerkzeuge, welche parallel Schaltungsmuster auf dem Substrat erzeugen, wodurch eine Produktivitätssteigerung erzielbar ist.

Das Leiterband wird vorzugsweise von einer Leiterbandspule abgespult, welche mit einer Antriebseinheit gekoppelt ist, so dass das Abspulen ruckfrei und mit geringer Krafteinwirkung auf das Leiterband erfolgt. Die Leiterbandspule wird bei der Verlegung des Leiterbandes ständig mitgeschwenkt, so dass das Leiterband nicht verdrillt wird.

In einer vorteilhaften Ausführungsform wird auf zumindest einer Oberflächenseite des Leiterbandes mittels einer Prägevorrichtung eine musterartige Prägung eingeprägt. Durch die Prägevorrichtung ist Leiterband, welches nicht eine im Montagebereich der elektronischen Bauelemente erforderliche Breite aufweist, durch einen Prägevorgang vor dem Verlegen so verformbar, dass eine erforderliche erhöhte Bandbreite des Leiterbandes in einem Bereich und Umgebungsbereich des zu kontaktierenden Bauelementes hergestellt ist. Ebenso kann es für einige Anwendungen vorteilhaft sein, Leiterdraht zum Verlegen des Schaltungsmusters zu verwenden und die in einem Montagebereich des Bauelementes und in seinem Umgebungsbereich erforderliche Breite des Leiterbandabschnittes durch Prägen herzustellen. Durch Prägen kann des Weiteren eine reliefartige Oberfläche vor dem Einbetten in das Substrat in das Leiterband eingeformt werden. D. h. es können beispielsweise Sicherheitsmerkmale oder Produktkennzeichnungen eingedrückt oder Mikrorauheiten zur Verbesserung der Kontaktierung im Kontaktierbereich erzeugt werden.

Zweckmäßigerweise werden nach Verlegen des Leiterbandes Kontaktierbereiche des Leiterbandes entisoliert. Der Isolierlack wird vorzugsweise mittels Laserstrahlung abgetragen, verdampft und/oder verbrannt. Sind die Kontaktierbereiche dem Laserstrahl zugewandt, so erfolgt das Entisolieren durch direktes Verbrennen des Isolierlackes mittels sehr langwelligen Infrarotlaserlichtes, zum Beispiel durch einen Energiestrahl eines CO2- Lasers. Liegt der Kontaktierbereich auf der dem Laserstrahl abgewandten Seite des Leiterbandabschnittes, so ist ein Laserstrahl mit einer Wellenlänge im nahen Infrarotbereich, zum Beispiel bei 900 nm zu verwenden; dieser heizt ein Leitermaterial des Kontaktierbereiches auf, so dass der Isolierlack auf beiden Seiten des Leiterbandes verdampft bzw. verbrennt. Dadurch ergeben sich folgende Vorteile:

Die Leiterbandabschnitte ergeben für nachfolgende Kontaktierungen große und ebene Flächen, die einerseits noch einen Lackisolator und andererseits lagedefinierte, entisolierte Kontaktierbereiche aufweisen. Die Entisolierung mittels Laser nach dem Verlegen kann eventuelle Fehllagen der Leiterbänder und/oder der Durchbrüche insofern kompensieren, dass nach Bildlageerfassung entsprechend vorgegebenen Bildmarken, Schaltungsmustern oder Durchbrüchen die entisolierten Kontaktierstellen im vorgegebenen Bereich erzeugt werden und somit ein isolierter Bereich des Leiterbandabschnittes in einem vorgesehenen Montagebereich des elektronischen Bauelementes nicht unnötig verringert werden muss.

In einer vorteilhaften Ausführungsform werden das Leiterband oder eine Mehrzahl von Leiterbändern auf einer Oberflächenseite des Substrates sich selbst und/oder sich gegenseitig kreuzend aufgebracht. Dadurch können mehrere unterschiedliche Schaltungsmuster auf einer Seite des Substrates angeordnet werden. Dabei liegen an einer Verbindungsstelle je ein Leiterbandabschnitt der Schaltungsmuster kreuzweise übereinander und beide Leiterbandabschnitte sind miteinander kontaktiert. Die Leiterbänder werden vorzugsweise durch ein Zusammenpressen und ein gleichzeitiges impulsartiges Erhitzen über 900°C für eine Zeitdauer bis zu 100 ms entisoliert und miteinander verschweißt. In einer weiteren Ausführungsform werden Kontaktierbereiche der Leiterbänder entisoliert, auf diese Kontaktierbereiche ein Lotmaterial oder ein Leitkleber aufgetragen und die Leiterbänder unter Aufschmelzen des Lotmaterials oder unter Aushärten des Leitklebers elektrisch miteinander verbunden. Des Weiteren kann das Leiterband oder eine Mehrzahl von Leiterbändern auf die beschriebene Weise auch auf beiden Oberflächenseiten des Substrates jeweils sich selbst und/oder sich gegenseitig kreuzend aufgebracht werden.

Es ist dabei vorteilhaft, wenn ein unterer Leiterbandabschnitt einen in Bezug auf die Leiterkreuzung großflächigen entisolierten Kontaktierbereich hat und die Entisolierung vor dem Verlegen des zweiten kreuzenden Schaltungsmusters erfolgt. Die Kontaktierung selbst kann mit unterschiedlichen Verfahren realisiert werden.

Das kostengünstigste Verfahren ist die Kontaktierung mittels impulsartigem Thermokompressionsschweißen, bei dem eine Thermode auf den Kreuzunasbereich aufsetzt, die Leiterbandabschnitte gegen das Substrat drückt und gleichzeitig die Thermode innerhalb kleiner gleich 0,1 Sekunden auf Temperaturen größer gleich 900 °C erhitzt wird.

Bei einem alternativen Verfahren wird vor dem Verlegen des zweiten Schaltungsmusters auf dem Kontaktierungsbereich Lotmaterial deponiert, danach wird das zweite Schaltungsmuster verlegt und anschließend mittels punktförmiger, kurzzeitiger und extremer Erhitzung des aufgelegten zweiten Leiterbandabschnittes die auf dem Lotmaterial liegende Isolierung zumindest teilweise zerstört und das Lotmaterial aufgeschmolzen, so dass das Lotmaterial die sich kreuzenden Leiterbandabschnitten verbindet.

Bei einem weiteren alternativen Verfahren werden nach dem Verlegen der sich kreuzenden Leiterbandabschnitte durch Entisolierung beider Leiterbandabschnitte nebeneinanderliegende Kontaktierbereiche geschaffen, wobei die Kante des oberen kreuzenden Leiterbandstückes zumindest partiell entisoliert wird, danach das Lotmaterial aufgebracht und durch punktförmige und kurzzeitige Erhitzung des Lotmateriales die Kontaktierung der kreuzenden Leiterbandabschnitte realisiert. Weitere alternative Kontaktiermethoden sind die Verwendung von elektrisch leitendem Kleber an Stelle von Lotmaterial oder die mechanische Verbindung der sich kreuzenden Leiterbandabschnitte mittels Mikroclinchen. Es ergeben sich folgende Vorteile: Mit der angegebenen Lösung sind auf einer Substratseite komplexere Schaltungen, auch mit unterschiedlichen Leiterbändern möglich. Es lassen sich sichere und sehr flache Verbindungsstellen herstellen.

In einer weiteren vorteilhaften Ausführungsform werden auf beiden Oberflächenseiten des Substrates Leiterbänder aufgebracht und durch einen Durchbruch im Substrat hindurch elektrisch miteinander verbunden. In einem ersten Verbindungsverfahren erfolgt die Kontaktierung durch Zusammendrücken beider Leiterbandabschnitte im Durchbruch und durch nachfolgendes Thermokompressionsschweißen. Bei einem alternativen Verbindungsverfahren wird nach Verlegen des ersten Leiterbandabschnittes in den Durchbruch ein metallisches Leiterstück in Durchbruchsgröße minus der Dicke der beidseitigen Leiterbandabschnitte eingesetzt, danach wird auf der anderen Substratseite die Schaltung verlegt und anschließend durch beidseitiges, zweimaliges Thermokompressionsschweißen die Durchkontaktierung vorgenommen.

Die Leiterbänder können des Weiteren auch auf beiden Oberflächenseiten des Substrats angeordnet werden, ohne durch den Durchbruch miteinander elektrisch verbunden zu werden. Sie können dabei auch einen Durchbruch lediglich überspannen und nicht über diesen elektrisch miteinander kontaktiert werden. Durch die Leiterbänder auf beiden Oberflächenseiten, welche miteinander elektrisch kontaktiert sein können oder auch nicht, können auf beiden Seiten des Substrates Schaltungsmuster erzeugt werden.

Bei einem zweiten alternativen Verbindungsverfahren wird nach dem Verlegen eines sehr breiten Leiterbandabschnittes, welcher den Durchbruch einseitig vollständig verschließt, und dem Herstellen des beabsichtigten entisolierten Kontaktierbereiches auf der Substratseite des Leiterbandabschnittes ein schmaler, den Durchbruch nur teilweise verschließender Leiterbandabschnitt verlegt und durch Laserenergieeintrag kurzzeitig soweit erhitzt, dass der Isolierlack auf der Durchbruchseite verdampft oder verbrennt und danach die Kavität mit Lotpaste gefüllt und schließlich die Lotpaste aufgeschmolzen.

Bei einem dritten alternativen Verbindungsveifahren wird nach dem Verlegen eines sehr breiten Leiterbandabschnittes, welcher den Durchbruch einseitig vollständig verschließt, und Herstellen des beabsichtigten entisolierten Kontaktierbereiches auf der Substratseite des Leiterbandabschnittes ein schmaler, den Durchbruch nur teilweise verschließender Leiterbandabschnitt verlegt und durch Laserenergieeintrag kurzzeitig soweit erhitzt, dass der Isolierlack auf der Durchbruchseite verdampft oder verbrennt, die Kavität mit elektrisch leitendem pastösen Füllstoff ausgefüllt. Die Aushärtung des Füllstoffes erfolgt schließlich nach Auflegen von Deckfolien auf das Substrat beim Laminiervorgang.

Es ergibt sich der Vorteil, dass mit geringem Aufwand eine oder mehrere Schaltungen auf beiden Seiten des Substrates miteinander elektrisch verbunden werden können und dass die Verbindungsstelle sicher in das Substrat bzw, in das Vorlaminat eingebettet ist.

Eine ergänzende Ausgestaltung ergibt sich für ein Substrat mit mindestens einem in oder auf jede Substratseite eingebetteten Schaltungsmuster, wobei sich mindestens ein elektronisches oder elektrisches Bauelement in mindestens einem Durchbruch der Substratfolie befindet und die zu beiden Seiten der Substratfolie weisenden Anschlussstellen des Bauelementes mit Kontaktierbereichen der Leiterbandabschnitte der Schaltungsmuster auf beiden Seiten der Substratfolie verbunden sind.

Nach dem Verlegen des Schaltungsmusters in oder auf eine Substratseite wird das Element in der Kavität platziert, anschließend das Schaltungsmuster in oder auf die zweite Substratseite verlegt und schließlich die Kontaktierung durch impulsartiges Thermokompressionsschweißen von beiden Substratseiten her vorgenommen.

Bei einer anderen Vorgehensweise werden nach Verlegen des Schaltungsmusters in oder auf eine Substratseite die Kontaktierbereiche der Leiterbandabschnitte durch Entisolierung geschaffen, und auf die Kontaktierbereiche wird Lotmaterial (zum Beispiel Lotpaste) deponiert, danach das elektronische Bauelement in der Kavität platziert und auf dessen Anschlussstellen wird ebenfalls Lotmaterial aufgetragen, anschließend das Schaltungsmuster in oder auf die zweite Substratseite verlegt, danach werden durch punktweise extreme Erhitzung des Leiterbandabschnittes die Kontaktierbereiche entisoliert und dabei erfolgt gleichzeitig die Kontaktierung dieser Bauelementanschlüsse. In einem nächsten Schritt werden durch punktweise Erhitzung die Kontaktierbereiche der Leiterbandabschnitte der ersten Substratseite mit den Bauelementanschlüssen durch Lötkontaktierung verbunden.

Bei einer weiteren Vorgehensweise werden nach Verlegen des Schaltungsmusters in oder auf eine Substratseite die Kontaktierbereiche der Leiterbandabschnitte durch Entisolierung erzeugt, danach wird Leitpaste auf die Kontaktierbereiche aufgebracht, das elektronische Bauelement in der Kavität platziert, auf dessen Anschlussstellen ebenfalls Leitpaste aufgebracht und in einem weiteren Schritt mindestens ein Schaltungsmuster in die zweite Substratseite verlegt, die Kontaktierbereiche durch punktweise extreme Erhitzung der Leiterbandabschnitte entisoliert, schließlich auf beide Substratseiten Deckfolien aufgelegt und durch Lamination mit dem Substrat unter Aushärtung des Leitklebers verbunden.

Es ergeben sich folgende Vorteile: In das Substrat können elektronische oder elektrische Bauelemente mit räumlich verteilten Anschlüssen montiert und kontaktiert werden; z.B. Batterien, Leuchtdioden, Piezoelemente usw.. Dabei sind bekannte Methoden der Kontaktierung anwendbar. Vorteilhaft sind auch vorbelotete oder mit thermoplastischem Leitkleber beschichtete elektronische Bauelementanschlüsse nutzbar. Die Kavitäten können durch Gießharze ausgefüllt werden; die elektrische Leitkleberkontaktierung, das Löten (zumindest bei niedrig schmelzenden Loten) und das Aushärten der kavitätsfüllenden Harze kann während des Laminierens erfolgen.

Bei einer weiteren vorteilhaften Ausgestaltung werden nach Verlegen des Schaltungsmuster in eine Substratseite die Kontaktierbereiche der Leiterbandabschnitte entisoliert, danach das elektronische Bauelement auf der Substratoberfläche platziert und die Bauelementanschlüsse mit den Kontaktierbereichen verbunden.

Bei einer ersten Ausgestaltung wird das Bauelement mit seiner Rückseite auf dem Substrat vorzugsweise durch Kleben befestigt, anschließend die Anschlussstellen des Bauelements mit den Kontaktierbereichen durch Feindrahtbonden oder Bändchenbonden verbunden und schließlich werden Bauelement, Kontaktierbereiche und der Feindraht bzw. das Kontaktierbändchen mittels härtbarer Vergussmasse geschützt.

Bei einer weiteren Ausgestaltung wird das Bauelement mittels flip chip- Kontaktierung mit den Kontaktierbereichen der Leiterbandabschnitte verbunden. Der Schutz des Bauelements und der Kontaktierbereiche erfolgt durch Klebstoff und Vergussmasse.

Bei einer dritten Augestaltung wird das Bauelement auf die Substratfolie aufgeklebt und die Kontaktierung erfolgt durch Aufbringen und Aufschmelzen von Lotmaterial oder durch Aufbringen und Aushärten von elektrisch leitendem Kleber. Eine Erweiterung dieser Ausgestaltung der erfindungsgemäßen Lösung ergibt sich dadurch, dass vor oder nach dem Kontaktieren eine Deckfolie mit einem Durchbruch in Flächengröße des Bauelementes und seiner Kontaktierung und der Dicke des Bauelementes einschließlich seiner Kontaktierung so auf die Substratfolie aufgebracht und zumindest im Umgebungsbereich des Durchbruches mit dieser durch Lamination verbunden wird, dass das Bauelement nach der Kontaktierung geschützt in der durch die Deckfolie geschaffenen Kavität liegt. Das Restvolumen der Kavität wird durch Klebstoff oder Vergussmasse ausgefüllt. Diese Ausgestaltung der erfinderischen Lösung ermöglicht es Substrate mit Schaltungsmustern aus Leiterband analog einer Leiterplatte zu verwenden ohne die Nachteile einer kostenaufwändigen und nicht mit weiteren thermoplastischen Schichten laminierfähigen ätzstrukturierten Leiterplatte und ohne die Nachteile eines mit kostenaufwändiger Leitpasten bedruckten und mehrfach thermisch vorbehandelten und geschrumpften Substrates zu haben.

Bei einer vorteilhaften Ausführungsform des Verfahrens wird ein Durchbruch im Substrat mittels einer ersten Deckfolie auf einer Oberflächenseite des Substrates, auf welcher das Schaltungsmuster angeordnet ist, einseitig verschlossen, in eine dadurch gebildete Kavität wird Klebstoff oder Vergussmasse dosiert, das elektronische Bauelement wird in die Kavität eingesetzt und mit Anschlüssen gegen Kontaktierbereiche des Leiterbandes gedrückt. Eine weitere erste Deckfolie wird auf eine Oberflächenseite des Substrates ohne Schaltungsmuster aufgelegt und in einem gemeinsamen Verfahrensschritt werden die beiden ersten Deckfolien und das Substrat mit auf- oder eingebrachtem Schaltungsmuster und darin eingesetztem elektronischen Bauelement unter Zusammenpressen laminiert, wobei die Anschlüsse des elektronischen Bauelements an die Kontaktierbereiche angedrückt und kontaktiert werden und der Klebstoff oder die Vergussmasse bei Laminiertemperatur ausgehärtet wird. Daraus resultiert eine hochproduktive Fertigung mit einer sehr geringen Anzahl von Verfahrensschritten.

Das erfindungsgemäße Verfahren und dessen Ausführungsformen ermöglichen die Herstellung von kontaktlosen Chipkarten, von komplexen Chipkarten und von einfachen elektrischen Schaltungen unter Verwendung dieses breiten Leiterbandes. Dadurch können sehr ebene, flache und sehr zuverlässige Schaltungen hergestellt werden, welche dünnen, ein- oder beidseitig mit Leiterbahnen versehenen Leiterplatten ähneln, diesen gegenüber jedoch die Vorteile einer sehr flexiblen Herstellung, einfach herzustellender elektrisch isolierter Leiterkreuzungen und eine Überquerung von Durchbrüchen aufweisen. Dies ist bei Leiterplatten nicht oder nur mit einem sehr hohen Aufwand möglich. Des Weiteren können definierte Kavitäten mit am Kavitätsboden befestigten Leiterbändern geschaffen werden und eine Chipkontaktierung in diesen Kavitäten ist durch Zusammenfassung der Schritte Aushärten des Chipkontaktierklebers, Ausfüllen der Restkavität mit Kleber und Laminieren vereinfacht. Die Kavitäten oder Durchbrüche im Substrat können mit dem breiten Leiterband sehr einfach überspannt werden.

Es sind mit hoher Produktivität, einer verringerten Anzahl von Arbeitsschritten und mit geringem Energie- und Materialaufwand sehr kostengünstig Schaltungsanordnungen in Form der oben genannten Produkte herstellbar, welche eine hohe optische Qualität, eine hohe Präzision des Leiterbahnmusters, eine geringe Toleranz elektrischer Kennwerte und eine hohe Zuverlässigkeit aufweisen. Insbesondere können zur Herstellung der Schaltungsanordnung Substrate ohne eine zusätzliche Kleberbeschichtung verwendet werden.

Das breite Leiterband ermöglicht zudem sehr breite Kontaktierflächen, die eine sichere Flip-Chip-Kontaktierung ermöglichen und Laser- oder Thermokompressionskontaktierungen erleichtern, da ebene und dünne Metallflächen den Energieeintrag und die Energieleitung vereinfachen und präziser steuern lassen als die im Stand der Technik verwendeten Runddrähte oder verdrillten Rechteckdrähte. Des Weiteren ist durch die breiten Leiterbänder eine aktive Oberfläche des an die Leiterbänder kontaktierten Halbleiterchips optisch sehr stark abgeschattet.

Eine Vorrichtung zur Erzeugung eines Schaltungsmusters auf einem Substrat umfasst eine Leiterbandspule, wobei die Leiterbandspule um eine horizontale Drehachse drehbar gelagert in einer Spulenaufnahme angeordnet, welche um eine vertikale Drehachse drehbar gelagert ist, wobei die Spulenaufnahme mittels einer Nachführeinrichtung bei Richtungsänderungen während eines Verlegens des Leiterbandes auf dem Substrat derart nachdrehbar ist, dass das Leiterband verdrillungsfrei tangential von der Leiterbandspule abspulbar ist.

Erfindungsgemäß umfasst die Vorrichtung ein zylinderförmiges oder konisches ultraschallangeregtes Verlegewerkzeug, welches zumindest über einen Teil seiner Länge eine das Leiterband führende Innenbohrung und eine ringförmige, in Innen- und Außenradius übergehende, senkrecht zu seiner Längsachse angeordnete Wirkfläche aufweist. Zudem weist die Vorrichtung erfindungsgemäß eine mit der Spulenaufnahme fest verbundene Halterung mit einer Umlenkrolle auf, wobei zwischen der Umlenkrolle und der Leiterbandspule eine vertikal bewegliche weitere Umlenkrolle mit einem Dämpfungsgewicht angeordnet ist, mittels welcher eine Leiterbandreserveschleife erzeugbar ist.

Mittels der Vorrichtung ist das Leiterband auf und/oder in dem Substrat gerade oder kreisbogenförmig in vorgegebenen Radien und knickfrei anordbar.

Durch die Leiterbandreserveschleife ist ein gleichmäßiges ruckfreies Verlegen des Leiterbandes sichergestellt. Durch die vertikal bewegliche Umlenkrolle mit Dämpfungsgewicht ist ein gleichmäßiges Abspulen des Leiterbandes und eine hohe Verlegegeschwindigkeit bei geringer Zugkraft auf das Leiterband sichergestellt. Durch die Leiterbandreserveschleife kann die Leiterbandabwicklung von der Leiterbandspule weitgehend kontinuierlich erfolgen, so dass die Leiterbandspule nicht ständig angerollt und wieder gestoppt werden muss. Durch die beschriebene Vorgehensweise erfolgt eine verdrillungsfreie Leiterbandzuführung zum Verlegewerkzeug, wird eine vorgebbare und geringe Leiterbandvorspannung erhalten und das Leiterband wird von der Leiterbandspule auch bei Verlegegeschwindigkeiten im Bereich von 10 cm/s bis 100 cm/s und starken Geschwindigkeitsänderungen (enge Radien; Mäandermuster) im Wesentlichen kontinuierlich abgespult. Es wird vermieden, dass Leiterband beim Abspulen längs zu dehnen und damit seine Geometrie, seine Festigkeit und seine elektrischen Kennwerte zu verändern.

Das Verlegewerkzeug ist ultraschallangeregt, so dass der Isolierlack des Leiterbandes aufschmelzbar ist. Bei Verwendung eines geeigneten Substrates ist auch dieses gegebenenfalls zumindest teilweise aufschmelzbar. Das Leiterband ist tangential von einem Spulenkörper abspulbar. Die Achse der zylinderförmigen oder konischen Leiterbandspule liegt in einer oder nahezu in einer parallelen Ebene zur Substratoberfläche.

Die Achse der Leiterbandspule wird in der zur Substratebene parallelen Achse drehbar gelagert. Beim Verlegen von Schaltungsmustern bei Richtungsänderungen des Leiterbandes auf dem Substrat wird die Leiterbandspule so um die zur Substratebene senkrechte Achse nachgeführt, dass das Leiterband stets verdrillungsfrei der Wirkfläche des Verlegewerkzeuges zugeführt wird. Soll das Leiterband über Umlenkeinrichtungen der Wirkfläche des Verlegewerkzeuges zugeführt werden, sind die Leiterbandspule und die mit ihr direkt oder indirekt verbundenen Umlenkeinrichtungen gleichsinnig und gleichwinklig durch Drehung entsprechend den Richtungs- und Winkeländerungen des zu verlegenden Schaltungsmusters so nachzuführen, dass das Leiterband verdrillungsfrei auf dem Substrat verlegbar ist und gegebenenfalls ist das Verlegewerkzeug ebenfalls entsprechend den Richtungs- und Winkeländerungen des zu verlegenden Schaltungsmusters nachzuführen durch Drehung seiner senkrecht zur Substratebene stehenden Achse. Dadurch ist sichergestellt, dass das Leiterband verdrillungsfrei dem Verlegewerkzeug zuführbar ist. Dies ist insbesondere bei einseitigen Richtungsänderungen wie beim Verlegen von Spulenmustern und konzentrischen Antennen unbedingt erforderlich.

Das Verlegewerkzeug ist zylinderstiftförmig oder konisch ausgelegt, und es weist zumindest über einen Teil seiner Länge eine das Leiterband zuführende Innenbohrung und eine ringförmige, in Innen- und Außenradius übergehende, parallel zu der zu bearbeitenden Substratoberfläche angeordnete Wirkfläche auf.

Das Verlegewerkzeug führt auf dem Substrat Relativbewegungen in der Substratebene aus, die exakt das zu erzeugende Schaltungsmuster darstellen. Die Relativbewegung kann durch Bewegen des Verlegewerkzeuges auf dem Substrat, durch Verfahren des Substrates unter dem aufgesetzten Verlegewerkzeug oder durch Bewegung des Verlegewerkzeuges und des Substrates erfolgen.

Die Bewegung des Verlegewerkzeugs und/oder des Substrats, um die Relativbewegung zu erzeugen, kann insbesondere in x-Richtung und/oder in y-Richtung eines dreidimensionalen Koordinatensystems erfolgen. Eine Bewegung in z-Richtung kann beispielsweise zum Aufsetzen des Verlegewerkzeugs auf das Substrat erfolgen. Die x-Richtung und die y-Richtung des dreidimensionalen Koordinatensystems spannen eine horizontale Ebene auf, die x-Richtung und die y-Richtung spannen mit der z-Richtung des dreidimensionalen Koordinatensystems jeweils eine vertikale Ebene auf.

Eine Drehung des Substrates und/oder des Verlegewerkzeugs um eine Drehachse senkrecht zur Substratoberfläche ist möglich, wobei die Drehung des Verlegewerkzeugs auch vorteilhaft ist. Die Drehung des Substrates ist jedoch nicht sehr sinnvoll, insbesondere nicht bei einer Mehrzahl parallel angeordneter Verlegewerkzeuge, welche parallel Schaltungsmuster auf dem Substrat erzeugen, wodurch eine Produktivitätssteigerung erzielbar ist.

In einer bevorzugten Ausführungsform ist zwischen der Leiterbandspule und dem Verlegewerkzeug eine Prägevorrichtung angeordnet, welche zweckmäßigerweise einen fest stehenden Amboss und einen beweglichen Amboss umfasst, wobei Prägefläche der Ambosse parallel zu Oberflächenseiten des zwischen den Ambossen hindurchgeführten Leiterbandes ausgerichtet sind. Besonders bevorzugt ist zumindest in die Prägefläche eines Ambosses ein Prägemuster eingebracht.

Dadurch sind Leiterbandabschnitte mit einer Verformungsbreite größer der Bandbreite des von der Leiterbandspule abgespulten Leiterbandes durch definiertes Prägen von Leiterbandstücken herstellbar durch die Prägevorrichtung mit zwei gegeneinander wirkenden Ambossen definierter Prägelänge, wobei die Ambossflächen vertikal oder nahezu vertikal angeordnet sind und das zu prägende Leiterband flächenparallel zwischen den Ambossen geführt ist. Entsprechend der Länge des zwischen Prägevorrichtung und Wirkfläche des Verlegewerkzeuges unter geringer Zugspannung stehenden Leiterbandes ist der Prägevorgang an der Stelle beim Verlegen des Schaltungsmusters zu starten, von der bis zum Erreichen des Umgebungsbereiches des zu montierenden Bauelementes diese Leiterbandlänge noch verlegt werden muss. Beim Prägen von Verformungsbreiten beträgt die Länge des zu prägenden Leiterbandabschnittes die Länge des Umgebunasbereiches des zu montierenden Bauelementes.

Diese Prägevorrichtung ist zur Vermeidung der Verdrillung des Leiterbandes beim Verlegen gleichsinnig und gleichwinklig mit der Leiterbandspule um die vertikale Achse drehbar. Es ist zweckmäßig die Abspulvorrichtung und die Prägevorrichtung mechanisch zu verbinden. Eine weitere Verbesserung ergibt sich, wenn die Prägeambosse mit unterschiedlichen und definierten Presskräften beaufschlagt werden können, wenn die Ambossflächen kühlbar sind und wenn zwei oder weitere Prägevorrichtungen im Leiterbandablauf angeordnet sind.

Durch das Prägen mit definierten Ambossgeometrien ergeben sich definiert breite Leiterbandabschnitte und Abschnittsbreiten, die breiter sind als das sonst für das Schaltungsmuster verlegte Leiterband. Durch Wahl der Presskräfte können bei Bedarf unterschiedliche Verformungsbreiten erzeugt werden. Die Kühlung und die damit sich ergebende Befeuchtung der Ambossflächen verhindert ein Anbacken der Isolierlacke an den Ambossflächen. Durch ein eingeprägtes Relief ist bei bestimmten Kontaktierungsarten, zum Beispiel flip chip- Kontaktierung, die Zuverlässigkeit des Kontaktes erhöht. Wird Leiterdraht zur Erzeugung des Schaltungsmusters verwendet, so sind mittels Prägen ebenfalls große Verformungsbreiten erzielbar.

Vorzugsweise ist zwischen der Prägevorrichtung und dem Verlegewerkzeugs eine Leiterbandführungsvorrichtung angeordnet, welche zweckmäßigerweise mit der Spulenaufnahme und mit der Prägevorrichtung verbunden ist. Besonders bevorzugt umfasst die Leiterbandführungsvorrichtung zwei vertikal untereinander angeordnete fest montierte Umlenkrollen und eine dazwischen angeordnete, federnd gelagerte und horizontal bewegliche Umlenkrolle. Diese federnd gelagerte Umlenkrolle ist durch eine Federkraft senkrecht zu einer virtuellen vertikalen Achse der beiden fest montierten Umlenkrollen maximal auslenkbar, d. h. aus dieser virtuellen Achse heraus auslenkbar, wobei diese virtuelle vertikale Achse durch Drehpunkte der beiden fest montierten Umlenkrollen verläuft.

Das Leiterband oder der Leiterdraht umschlingt die beweglich gelagerte Umlenkrolle auf der anderen Seite als auf den fest montierten Umlenkrollen. Die bewegliche Umlenkrolle ist beim Verlegen des Schaltungsmusters aus der Verbindungslinie der beiden fest montierten Umlenkrollen maximal federnd ausgelenkt und der Leiterdraht oder das Leiterband bildet eine Speicherschleife. Die Federkraft ist so bemessen, dass sich bei einer Zugkraftwirkung auf den Leiterdraht oder das Leiterband die Auslenkung verringert. Beim Verlegen eines Schaltungsmusters ist die federnd gelagerte Umlenkrolle maximal ausgelenkt.

Während des Prägens tritt ein Ablaufstopp des Leiterdrahtes oder Leiterbandes von der Leiterdraht- oder Leiterbandspule auf, der eine sofortige Erhöhung der Zugkraft auf den Leiterdraht oder das Leiterband bewirkt. Dadurch vermindert sich die Auslenkung der federnd gelagerten Umlenkrolle, so dass der Leiterdraht oder das Leiterband aus der Speicherschleife frei gebbar ist. Dadurch ist auch während des Prägens ein ununterbrochener Verlegevorgang ermöglicht. Es ergibt sich dadurch folgender Vorteil: Das Prägen der bandartigen Leiterstücke ist an und für sich auch bei Stopp des Verlegens möglich; aber mit Einsatz der Leiterbandführungsvorrichtung ist eine höhere Verlegeproduktivität erzielbar, da während des Prägens kein Verlegestopp erforderlich ist. Die angegebene Leiterbandführungsvorrichtung stellt nur das Prinzip einer Leiterbandspeicherung dar; die Leiterbandspannung kann ebenso über Sensoren überwacht und die bewegliche Rolle über spezielle Antriebe gehalten oder bewegt werden. Bei Leiterbändern, die bereits die erforderliche Breite im Montagebereich der elektronischen Bauelemente aufweisen, sind die Präge- und Führungsvorrichtungen nicht erforderlich.

In einer weiteren bevorzugten Ausführungsform ist die Leiterbandspule mit einer Antriebseinheit gekoppelt. Dies ist beispielsweise mittels eines Motors mit einer Kraftübertragung zur Leiterbandspule realisierbar, zum Beispiel mittels Antriebsrollen, Abtriebsrollen und/oder mittels zumindest eines Antriebsriemens. Zudem weist die Vorrichtung eine vertikal bewegliche Umlenkrolle mit Dämpfungsgewicht auf. Auf diese Weise ist eine Leiterbandreserveschleife von der Leiterbandspule abrollbar, so dass ein gleichmäßiges ruckfreies Verlegen des Leiterbandes sichergestellt ist. Durch die Antriebseinheit und zudem durch die vertikal bewegliche Umlenkrolle mit Dämpfungsgewicht sind ein gleichmäßiges Abspulen des Leiterbandes und eine hohe Verlegegeschwindigkeit bei geringer Zugkraft auf das Leiterband sichergestellt.

Zur Überwachung der Leiterbandreserveschleife weist die Vorrichtung beispielsweise zumindest einen Sensor auf. Dadurch ist die Antriebseinheit stets derart steuerbar und/oder regelbar, dass stets ausreichend Leiterband zum Verlegen zur Verfügung steht, d. h. dass auch stets eine ausreichende Leiterbandreserveschleife verfügbar ist. Durch die Leiterbandreserveschleife kann die Leiterbandabwicklung von der Leiterbandspule weitgehend kontinuierlich erfolgen, so dass die Leiterbandspule nicht ständig angerollt und wieder gestoppt werden muss.

Das Verlegewerkzeug kann ebenfalls an der Spulenhalterung befestigt sein und sich mitdrehen, eine separate Aufhängung des Verlegewerkzeuges ist jedoch zu bevorzugen, denn dies ermöglicht eine bessere Dynamik des Verlegewerkzeuges insbesondere bei Bewegungen senkrecht zur Substratoberfläche, ermöglicht eine bessere Kraftsteuerung und ermöglicht eine gleichmäßigere Abnutzung der Wirkfläche des Verlegewerkzeuges. Wesentlich ist, dass das Leiterband knickfrei und ohne Führung über Umlenkkanten von der Umlenkspule in das Verlegewerkzeug fällt. Sobald ein Leiterbandmuster verlegt ist und das Werkzeug unter Abheben von der Substratoberfläche eine andere Position einnehmen soll, muss zuvor eine Bandklemme geschlossen werden, um ein Rückziehen des Lcitcrbandes durch die Umlenkrolle oder eine Veränderung der Leiterbandlage im Verlegewerkzeug zu verhindern. Vor Verlegebeginn ist die Bandklemme wieder zu öffnen. Durch die beschriebene Vorgehensweise erfolgt eine verdrillungsfreie Leiterbandzuführung zum Verlegewerkzeug, wird eine vorgebbare und geringe Leiterbandvorspannung erhalten und das Leiterband wird von der Leiterbandspule auch bei Verlegegeschwindigkeiten im Bereich von 10 cm/s bis 100 cm/s und starken Geschwindigkeitsänderungen (enge Radien; Mäandermuster) im Wesentlichen kontinuierlich abgespult. Es wird vermieden, dass Leiterband beim Abspulen längs zu dehnen und damit seine Geometrie, seine Festigkeit und seine elektrischen Kennwerte zu verändern. Zur Sicherstellung der Leiterbandreserveschleife sind auch weitere technische Möglichkeiten einsetzbar, beispielsweise mittels Luftströmung.

Die elfindungsgemäße Vorrichtung und deren Ausführungsformen ermöglicht ein kontinuierliches gerades und insbesondere kurvenförmiges und spulenförmiges, völlig ebenes, verdrillungsfreies, faltenfreies, rissfreies und knitterfreies flächiges Verlegen und Verkleben eines breiten Leiterbandes in beliebigen, auch konzentrischen Mustern auf einem Substrat.

Mit der Vorrichtung mit einer mitschwenkenden Leiterbandspule können Schaltungsanordnungen mit kleinen Radien hergestellt werden, d. h. die Radien sind größer als etwa das Vierfache der Leiterbandbreite. Dadurch sind alle sinnvollen Schaltungsmuster mit dem Leiterband und den damit erzielbaren Radien herstellbar.

Die Vorrichtung weist in allen Ausführungsformen zweckmäßigerweise eine Trenneinrichtung auf, mittels welcher das Leiterband durchtrennbar ist, so dass auf dem Substrat verlegtes Leiterband von noch nicht verlegtem Leiterband, welches sich noch in der Vorrichtung befindet, abtrennbar ist, zum Beispiel nachdem das Schaltungsmuster auf dem Substrat vollständig erzeugt und das Verlegen des Leiterbandes abgeschlossen ist.

Das Leiterband sollte auf der Spule parallel nebeneinander und verdrillungsfrei Lage auf Lage gespult sein, um jegliche Vorschädigungen (Knicke, Verwölbungen, Verhackungen des Leiterbandes auf der Leiterbandspule zu vermeiden und die einfache Abspulung sicherzustellen.

Unter dem Begriff Leiterband ist ein bandförmig ausgeformter elektrischer Leiter zu verstehen, dessen Breite mindestens das Vierfache seiner Dicke beträgt.

Bevorzugt beträgt die Breite des Leiterbandes das Zehnfache bis das Hundertfache seiner Dicke.

Vorteilhafterweise weist das Leiterband eine Dicke von mindestens 5 µm auf.

Vorzugsweise weist das Leiterband eine Breite von 0,2 mm bis 1 mm, besonders bevorzugt 0,25 mm bis 1 mm und eine Dicke von 10 µm bis 50 µm auf.

Ausführungsbeispiele der Erfindung werden im Folgenden anhand von Zeichnungen näher erläutert.

Darin zeigen:
- Figur 1a: eine erste Ausführungsform von lackisoliertem Leiterband im Querschnitt,
- Figur 1b: eine zweite Ausführungsform von lackisoliertem Leiterband im Querschnitt,
- Figur 2: einen Ausschnitt aus einem Substrat mit einem Durchbruch und verlegten Leiterbändern in Draufsicht,
- Figur 3: einen Querschnitt durch ein Substrat mit verlegten Leiterbändern,
- Figur 4a: eine nicht beanspruchte Vorrichtung zur Erzeugung eines Schaltungsmusters in einer ersten Seitenansicht,
- Figur 4b: eine nicht beanspruchte Vorrichtung zur Erzeugung eines Schaltungsmusters in einer weiteren Seitenansicht,
- Figur 5: eine weitere nicht beanspruchte Vorrichtung zur Erzeugung eines Schaltungsmusters,
- Figur 6: ein Substrat mit einer durch Leiterbänder und ein elektronisches Bauelement gebildeten elektronischen Schaltung in Draufsicht,
- Figur 7: einen Querschnitt des Substrates mit einer durch Leiterbänder und ein elektronisches Bauelement gebildeten elektronischen Schaltung aus Figur 6,
- Figur 8: einen Querschnitt durch ein Substrat mit einer in einem Durch- bruchsbereich aufgelegten Deckfolie während eines partiellen Anheftens von Leiterbandabschnitten und des Substrates an die Deckfolie,
- Figur 9: einen Querschnitt durch ein flip chip-kontaktiertes elektro- nisches Bauelement in einem vergossenen Durchbruch eines Substrates,
- Figur 10: einen Querschnitt eines Substrates mit einer durch Leiterbänder und ein elektronisches Bauelement gebildeten elektronischen Schaltung und zwei Deckfolien,
- Figur 11: einen Querschnitt durch einen auf einer Substratoberfläche befestigten und vergossenen Halbleiterchip mit Drahtverbindungen zu Leiterbandabschnitten,
- Figur 12: einen Querschnitt einer weiteren Ausführungsform eines Substrates mit einer durch Leiterbänder und ein elektronisches Bauelement gebildeten elektronischen Schaltung und zwei Deckfolien,
- Figur 13: eine schematische Darstellung einer Thermokompressions- kontaktierung einer Leiterbandkreuzung auf einer Substratseite im Querschnitt,
- Figur 14: eine in einem Durchbruch zusammengedrückte und durch Thermokompressionsschweißen verbundene Leiterband- kreuzung im Querschnitt,
- Figur 15: eine Leiterbandverbindung mittels eines distanzüberbrücken- den Metallstückes im Querschnitt,
- Figur 16: ein beidseitig kontaktiertes elektronisches Bauelement in einem Durchbruch eines Substrates im Querschnitt, und
- Figur 17: eine erfindungsgemäße Vorrichtung zur Erzeugung eines Schaltungsmusters auf einem Substrat.

Einander entsprechende Teile sind in allen Figuren mit den gleichen Bezugszeichen versehen.

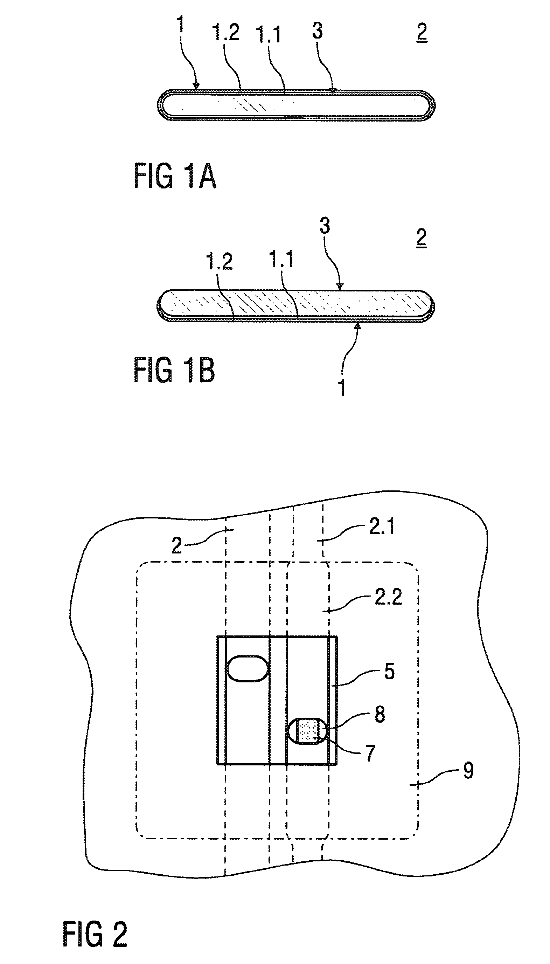

In Figur 1a ist ein allseitig mit einem Isolierlack 1 beschichtetes Leiterband 2 in einem Querschnitt dargestellt. Das Leiterband 2 ist aus Kupfer oder einer Kupferlegierung, beispielsweise aus Kupfer-Zinn-Bronze CuSn 6, welches eine dünne Oberflächenschicht 3 aus einem Edelmetall aufweist. Im hier dargestellten Beispiel ist dies eine Silberschicht mit einer Dicke von ca. 0,5 µm. Der Isolierlack 1 ist gebildet aus einer etwa 1 µm dicken Kernlackschicht 1.1 mit einer Erweichungstemperatur größer 240 °C, und einer Backlackschicht 1.2 mit einer Dicke von etwa 3 µm und einer Erweichungstemperatur größer 130 °C. Das Metall des Leiterbandes 2 weist eine Dicke von beispielsweise 7 µm und eine Breite von 0,32 mm auf.

In Figur 1b ist ein Leiterbandquerschnitt gleicher Abmessung gezeigt, bei welchem der Isolierlack 1 nur auf einer Oberflächenseite des Leiterbandes 2 aufgetragen ist. Mit dieser Oberflächenseite ist das Leiterband 2 auf einem Substrat 4 befestigbar.

In Fig. 2 ist in der Draufsicht ein Flächenteil eines Substrates 4 aus 150 µm dickem Polycarbonat mit einem Durchbruch 5 der Größe 1,5 x 1,5 mm² dargestellt. An einer unteren Seite des Substrates 4 befinden sich, den Durchbruch 5 querend, zwei Leiterbänder 2, 2.1, wobei das erste Leiterband 2 mit einer Breite hergestellt und verlegt wurde, die den Anforderungen an die Kontaktierung und Befestigung eines in den Durchbruch 5 zu montierenden Bauelementes 6 entspricht, während ein zweites, schmaleres Leiterband 2.1 in einem Leiterbandabschnitt 2.2 durch Prägen vor dem Verlegen auf eine Verformungsbreite verformt wurde, die Anforderungen einer Kontaktierung und Befestigung des elektronischen Bauelementes 6 in diesem Durchbruch 5 genügt.

Mit dem Prägen ist gleichzeitig in das Leiterband 2, 2.1 eine musterartige Prägung 7 in einem Kontaktierbereich 8 als Rautierung eingebracht worden. Ein etwa 2 mm breiter Rand um den Durchbruch 5 herum stellt einen Umgebungsbereich 9 des Durchbruches 5 bzw. des zu montierenden Bauelementes 6 dar. Die Ausdehnung des Umgebungsbereiches 9 in einer Richtung entspricht der Länge des Leiterbandabschnittes 2.2, der durch Prägen verformt wurde. Die Kontaktierbereiche 8 auf beiden Leiterbändern 2, 2.1 haben eine Größe von je ca. 0,3 x 0,4 mm².

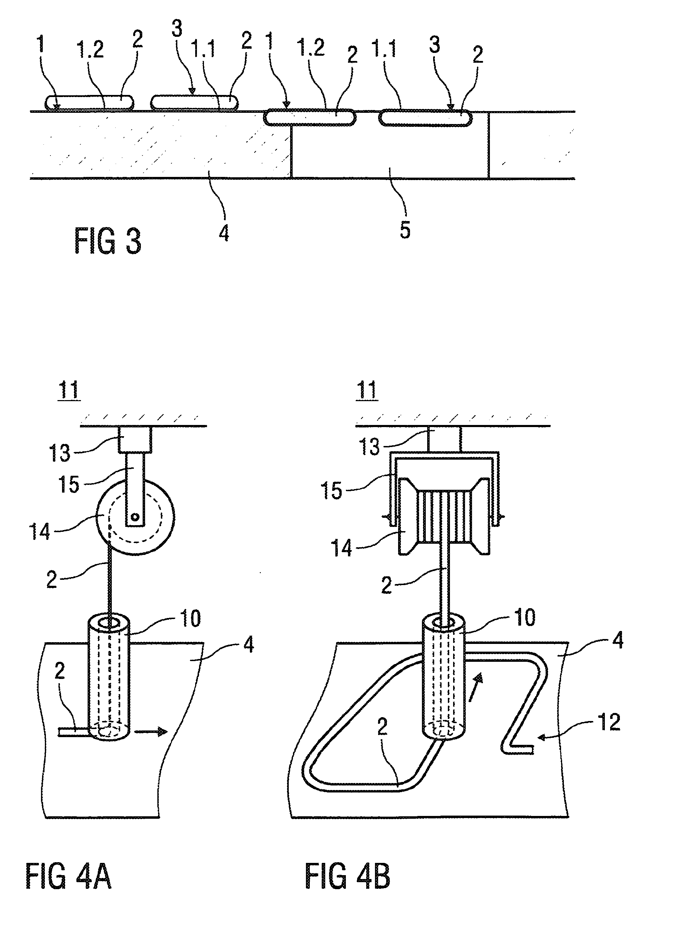

Im Querschnitt sind in Fig. 3 unterschiedliche Leiterbänder 2, die unterschiedlich tief in oder auf eine Seite des thermoplastischen Substrates 4 verlegt sind, dargestellt. Zwei Leiterbänder 2 sind nicht in das Substrat 4 eingebettet, eine Verbindungsfläche des Substrates 4 mit der Backlackschicht 1.2 der Leiterbänder 2 ist identisch mit der Oberfläche des Substrates 4. Die Leiterbänder 2 sind nur auf der Oberflächenseite zum Substrat 4 beschichtet mit dem Isolierlack 1. Da die zweite Oberflächenseite des Leiterbandes 2 keinen Isolierlack 1 aufweist, können auf dieser gesamten Oberflächenseite des Leiterbandes 2 Kontaktierungen vorgenommen werden. Die den Durchbruch 5 querenden Leiterbänder 2 sind in das Substrat 4 unter Verdrängung von Substratmaterial verlegt.

Wesentlich für das Verlegen von Leiterbändern 2, 2.1 ist, dass das Leiterband 2, 2.1 verdrillungsfrei einem Verlegewerkzeugs 10 einer Vorrichtung 11 zur Erzeugung eines Schaltungsmusters 12 zugeführt wird. Dies ist gegeben durch eine in den Figuren 4a und 4b dargestellte Aufhängungsvorrichtung 13 für eine Leiterbandspule 14, bei der eine Spulenaufnahme 15, welche die Leiterbandspule 14 waagerecht aufnimmt, um eine vertikale Achse drehbar gelagert ist. Mittels einer nicht dargestellten Nachführeinrichtung wird die Spulenaufnahme 15 und damit die Leiterbandspule 14 so in einer Horizontalen gedreht, dass entsprechend des zu erzeugenden Schaltungsmusters 12 auf dem Substrat 4 die Oberfläche des Leiterbandes 2 stets in Vorschubrichtung des Verlegewerkzeuges 10 zeigt. In den Figuren 4a und 4b sind zwei Situationen mit unterschiedlichen Bewegungsrichtungen gezeigt. Insbesondere bei der Verlegung von spulenartigen oder konzentrischen Schaltungsmustern 12 ist eine Nachführung der Spulenaufnahme 15 bzw. der Leiterbandspule 14 dringend erforderlich, soll das Leiterband 2 des gesamten Schaltungsmusters 12 verdrillungsfrei in das Substrat 4 eingebettet sein.

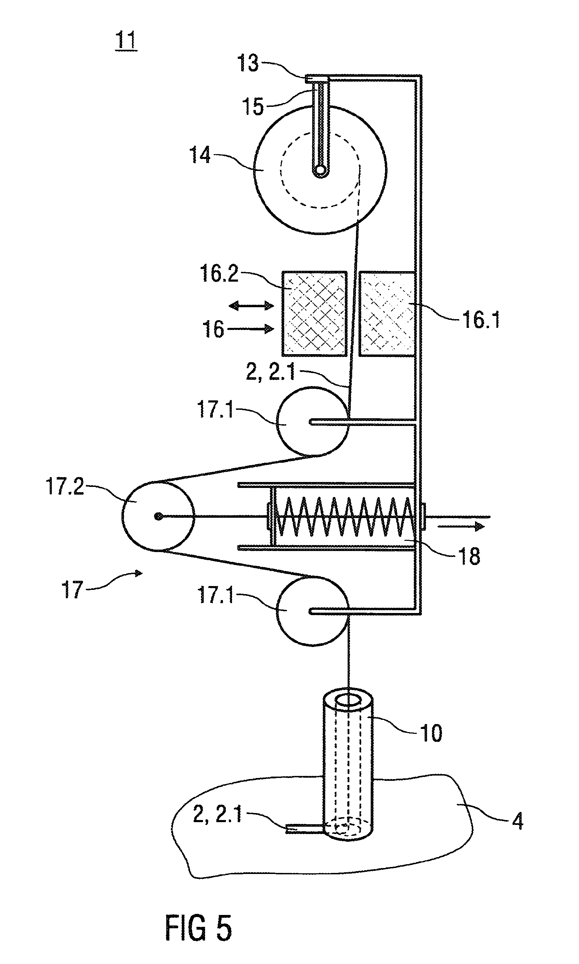

In Figur 5 ist eine weitere Ausführungsform der Vorrichtung 11 zur Erzeugung des Schaltungsmusters 12 dargestellt. Diese umfasst eine Prägevorrichtung 16 mit einem fest stehenden Amboss 16.1 und einem beweglichen Amboss 16.2 und eine Leiterbandführungsvorrichtung 17, welche vorzugsweise fest mit der drehbaren Spulenaufnahme 15 verbunden sind, damit eine verdrillungsfreie Leiterbandführung sichergestellt ist. Nach tangentialem Abzug des Leiterbandes 2, 2.1 von der Leiterbandspule 14 durchläuft das Leiterband 2, 2.1 oder ggf. ein Leiterdraht die Prägevorrichtung 16, deren fest stehender Amboss 16.1 und deren beweglicher Amboss 16.2 sich in geringem Abstand flächenparallel gegenüberstehen.

Eine vertikale Ambosslänge entspricht der Länge des Umgebungsbereiches 9, wenn es sich um ein schmales Leiterband 2.1 oder um Leiterdraht handelt, dessen Breite durch Verformung vergrößert werden soll. Sind musterartige Prägungen 7, beispielsweise Zeichen oder Reliefs zu prägen, bestimmt eine Zeichenvorgabe oder das Relief eine vertikale Länge des fest stehenden Ambosses 16.1 und oder des beweglichen Ambosses 16.2. Der bewegliche Amboss 16.2 presst mit vorgegebener definierter Kraft das Leiterband 2.1 auf den fest stehenden Amboss 16.1 und verformt den Leiterbandabschnitt 2.2 entsprechend der vertikalen Ambosslänge auf die vorgegebene Breite. Die Ambosse 16.1, 16.2 sind im Beispiel gekühlt auf Temperaturen unter -10 °C, um zu erreichen, dass eine sich auf den Prägeflächen der Ambosse 16.1, 16.2 niederschlagende Wasserhaut das Anbacken der Backlackschicht 1.2 des Leiterbandabschnitts 2.2 an den Ambossflächen 16.1, 16.2 verhindert. Soll der geprägte Leiterbandabschnitt 2.2 eine musterartige Prägung 7 aufweisen, so ist ein entsprechendes Prägerelief in mindestens einem der Ambosse 16.1, 16.2 vorzusehen.

Durch das Pressen der Ambossflächen gegeneinander stoppt ein Abzug des Leiterdrahtes oder des Leiterbandes 2, 2.1 von der Leiterbandspule 14. Die Leiterbandführungsvorrichtung 17 mit ihren untereinander in Leiterbandablaufrichtung angeordneten fest angeordneten Umlenkrollen 17.1 und einer über eine im Beispiel angegebenen Federlagerung 18 horizontal bis zu einer maximalen und justierbaren Stellung ausgelenkten, an der Federlagerung 18 befestigten und somit beweglich gelagerten Umlenkrolle 17.2 erzeugt eine Leiterbandspeicherung in der Art, dass eine durch einen Stopp des Leiterband- oder Leiterdrahtablaufes während des Prägens der musterartige Prägung 7 oder des Leiterbandabschnittes 2.2 bei weiterem Verlegen des Leiterbandes 2, 2.1 bzw. des Leiterdrahtes im Leiterband 2, 2.1 bzw. im Leiterdraht erzeugte erhöhte Zugspannung die bewegliche Umlenkrolle 17.2 gegen die Federlagerung 18 schiebt und somit weiteres Leiterband 2, 2.1 oder weiteren Leiterdraht zum Verlegen frei gibt. Nach Beendigung des Prägens gleitet die Federlagerung 18 mit der beweglichen Umlenkrolle 17.2 gedämpft zurück in eine justierbare maximale Auslenkungsstellung.

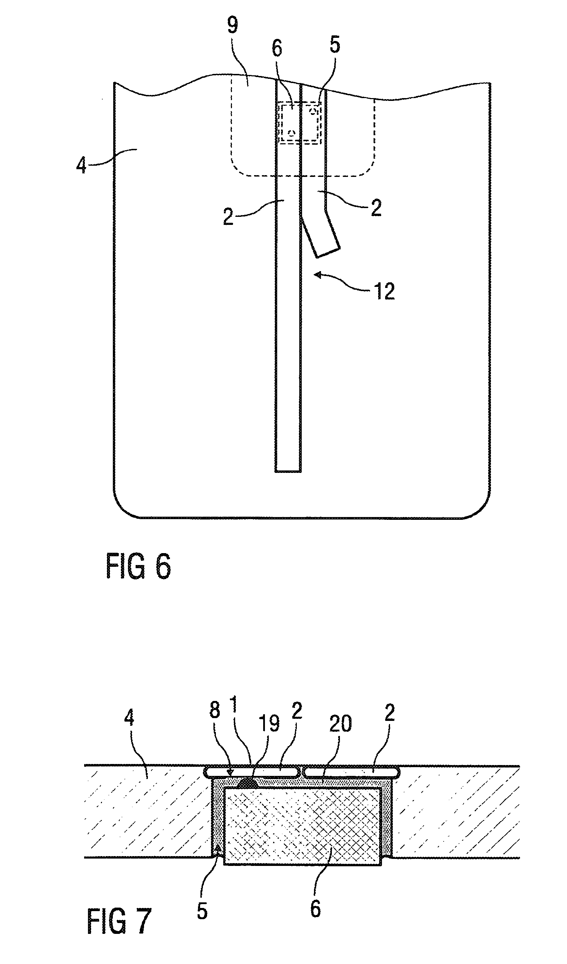

Ein Teil eines kartenähnlichen Substrates 4 mit einem Teil einer einfachen, verlegten UHF-Antenne als Schaltungsmuster 12 ist in der Draufsicht in Fig. 6 gezeigt. Das Schaltungsmuster 12 besteht aus zwei nahezu linearen, über dem Durchbruch 5 und dessen Umgebungsbereich 9 parallel verlaufenden und sich berührenden Leiterbändern 2. Die Leiterbänder 2 sind allseitig mit Isolierlack 1 beschichtet. Die Breite des Leiterbandes 2 beträgt 0, 4 mm. Die Größe des Durchbruches 5 beträgt 0,7 x 0,7 mm², und eine Durchbruchsfläche ist einseitig durch die verlegten Leiterbänder 2 verschlossen. In den Durchbruch 5 ist das Bauelement 6 eingesetzt.

Diese Situation ist vergrößert und im Querschnitt in Fig. 7 angegeben. Die Dicke des Substrates 4 aus Polycarbonat beträgt 200 µm, die Dicke des Leiterbandes 2 beträgt 40 µm, die Dicke des Bauelementes 6, welches ein Halbleiterchip ist, beträgt 150 µm und eine Höhe von Anschlüssen 19 des Bauelementes 6, welche als Kontakthügel ausgeformt sind, beträgt 30 µm. Der Halbleiterchip weist eine Fläche von 0,55 x 0,55 mm² auf. Das Bauelement 6 ist über seine beiden Anschlüsse 19 mit den beiden Kontaktierbereichen 8 der den Durchbruch 5 querenden Leiterbänder 2 verbunden. Ein Zwischenraum zwischen einer Oberfläche des Bauelementes 6 mit seinen Anschlüssen 19 sowie ein Zwischenraum zwischen dem Substrat 4 bzw. zwischen den Leiterbändern 2 und dem Bauelement 6 ist mit einem ausgehärteten Klebstoff oder Vergussmasse 20, einem so genannten Underfiller, ausgefüllt. Das Substrat 4 mit den eingebrachten Leiterbändern 2 und dem eingesetzten, kontaktierten und durch Klebstoff oder Vergussmasse 20 an fünf Flächen geschütztem Bauelement 6 weist nur geringe Unebenheiten auf.

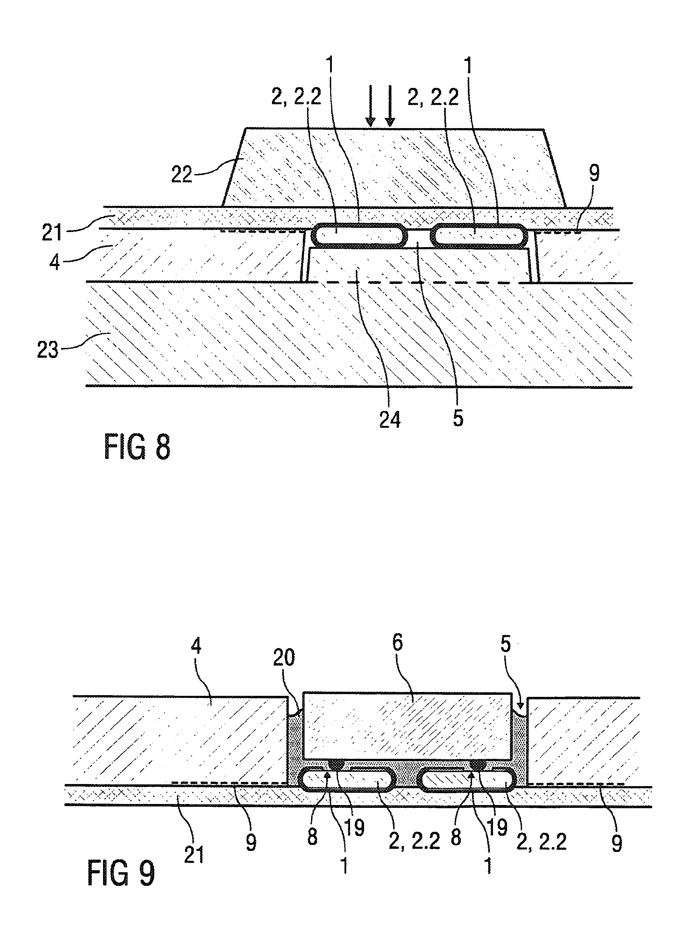

Figur 8 zeigt die Situation nach dem Verlegen des Schaltungsmusters 12 in eine Seite des thermoplastischen Substrates 4 während eines partiellen Fixierens einer auf eine Seite des Substrates 4 aufgebrachten ersten thermoplastischen Deckfolie 21 und des Anpressens der Leiterbandabschnitte 2.2 von einer offenen Seite des Durchbruches 5 her an die erste Deckfolie 21. Ein Laminierstempel 22 drückt die erste Deckfolie 21 im Umgebungsbereich 9 des Durchbruches 5 gegen das Substrat 4 und gegen die mit Isolierlack 1 beschichteten Oberflächen der Leiterbandabschnitte 2.2. Im Beispiel ist der Umgebungsbereich 9 des Durchbruches 5 ein 2 mm breiter Rand um den Durchbruch 5 herum.

Der Laminierstempel 22 ist im Beispiel auf 200°C erwärmt für die erste Deckfolie 21 aus Polycarbonat; ein Auflagetisch 23 und ein in den Auflagetisch 23 eingebrachter und in den Durchbruch 5 ragender Stempel 24 sind unbeheizt bzw. lediglich auf eine Temperatur signifikant unter einem Erweichungspunkt des Substrates 4 und der ersten Deckfolie 21 erwärmt. Ein Laminierdruck, eine Temperatur des Laminierstempels 22 und eine Laminierzeit sind in Abhängigkeit von einer Dicke des thermoplastischen Substrats 4 und der ersten thermoplastischen Deckfolie 21 derart vorgegeben, dass sich ein Anheften der ersten Deckfolie 21 an die Oberfläche des Substrates 4 im Umgebungsbereich 9 des Durchbruches 5 und an die den Durchbruch 5 querenden Leiterbandabschnitte 2.2 ergibt, so dass die Leiterbandabschnitte 2.2 plan an der ersten Deckfolie 21 fixiert sind. Übrige Bereiche der ersten Deckfolie 21 liegen auf dem Substrat 4 nur auf.

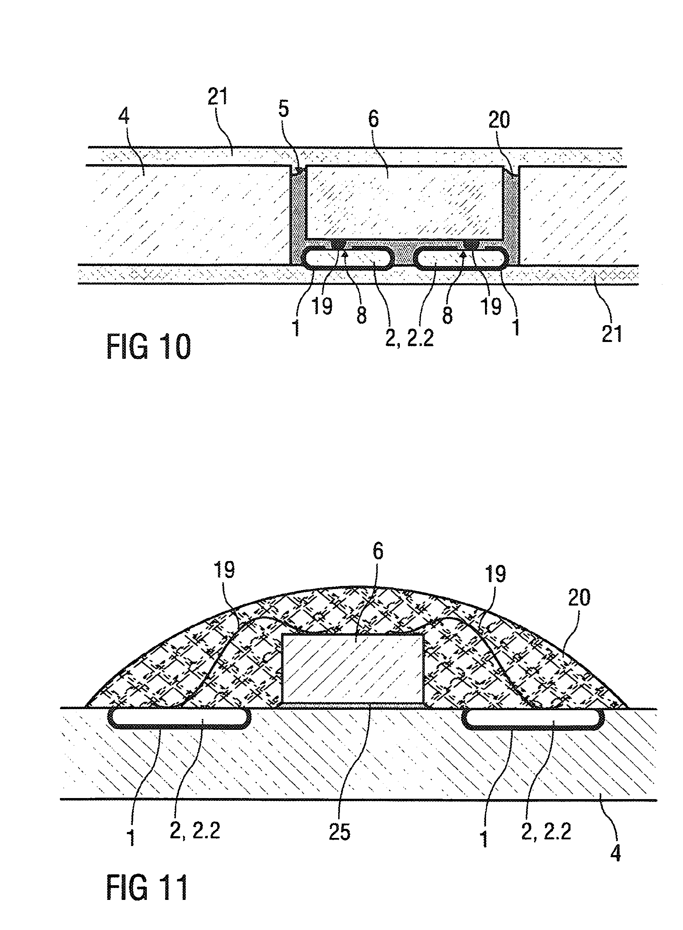

Fig. 9 gibt den Durchbruchsbereich aus Fig. 8 nach dem Einbringen des elektronischen Bauelementes 6 und einem Vergießen mit dem härtbaren Klebstoff oder der Vergussmasse 20 und Fig. 10 nach dem Auflegen einer weiteren ersten Deckfolie 21 auf die nicht mit einem Schaltungsmuster 12 versehene Seite des Substrates 4 und einem ganzflächigen Vorlaminieren der dadurch gebildeten Folienschichtung wider. Das elektronische Bauelement 6 ist ein Halbleiterchip, dessen Anschlüsse 19 Kontakthügel aus Gold, im Beispiel stud bumps, sind.

In den Durchbruch 5, welcher durch die Leiterbänder 2 und die erste Deckfolie 21 auf der Seite des Substrates 4, auf welcher das Schaltungsmuster 12 angeordnet ist, einseitig verschlossen ist, wodurch eine Kavität ausgebildet ist, ist in einem ersten Schritt Klebstoff oder Vergussmasse 20 dosiert worden, in einem zweiten Schritt ist das Bauelement 6 mit den Anschlüssen 19 gegen die Kontaktierbereiche 8 der Leiterbandabschnitte 2.2 platziert und gedrückt worden.

Ein Typ des Klebstoffs oder der Vergussmasse 20 ist so gewählt, dass nach Auflage einer weiteren ersten Deckfolie 21 auf die Seite des Substrates 4 ohne Schaltungsmuster 12 während der Lamination der beiden ersten Deckfolien 21 und des Substrats mit auf- oder eingebrachtem Schaltungsmuster 12 und darin eingesetztem elektronischen Bauelement 6 unter Zusammenpressen der Schichtung und dadurch bewirktem Andrücken des Bauelementes 6 mit seinen Anschlüssen 19 an die Kontaktierbereiche 8 die Aushärtung des Klebstoffs oder der Vergussmasse 20 bei Laminiertemperatur erfolgt. Dadurch erfolgt das Kontaktieren des elektronischen Bauelementes 6 und das Laminieren in einem gemeinsamen Verfahrensschritt. Der Klebstoff oder die Vergussmasse 20 ist im ersten Schritt so dosiert worden, dass die Kavität nach Einsetzen des Bauelementes 6 nahezu vollständig gefüllt ist. Durch einen derartigen Verfahrensablauf ist das schichtsymmetrische und sehr ebene, dünne Vorlaminat in Fig. 10 gebildet.

Ein weiteres Beispiel der möglichen Nutzung des mit einem Schaltungsmuster 12 versehenen Substrates 4 ist in Fig. 11 gezeigt. Direkt auf die Oberfläche des Substrates 4 zwischen zwei Leiterbandabschnitte 2.2 ist mittels eines Chipklebers 25 ein Bauelement 6, im hier dargestellten Beispiel ein Halbleiterchip, mit seiner Rückseite aufgeklebt. Die Leiterbänder 2 sind nur auf der dem Substrat 4 zugewandten Oberflächenseite mit Isolierlack 1 beschichtet. Die Anschlüsse 19 des Bauelementes 6, welche mit den Kontaktierbereichen 8 der Leiterbänder 2 elektrisch verbunden sind, sind im hier dargestellten Ausführungsbeispiel durch Aluminiumfeindraht gebildet und durch Ultraschallkontaktierung kontaktiert. Zum Schutz des Bauelementes 6, der Kontaktierbereiche 8 der Leiterbänder 2 und der durch Feindrähte gebildeten Anschlüsse 19 des Bauelementes 6 gegen Feuchtigkeit und mechanische Beschädigung dient ein Vergießen mittels Klebstoff oder Vergussmasse 20 und ein anschließendes Aushärten, wodurch das Bauelement 6, dessen Anschlüsse 19 und die Kontaktierbereiche 8 eingeschlossen und geschützt sind.

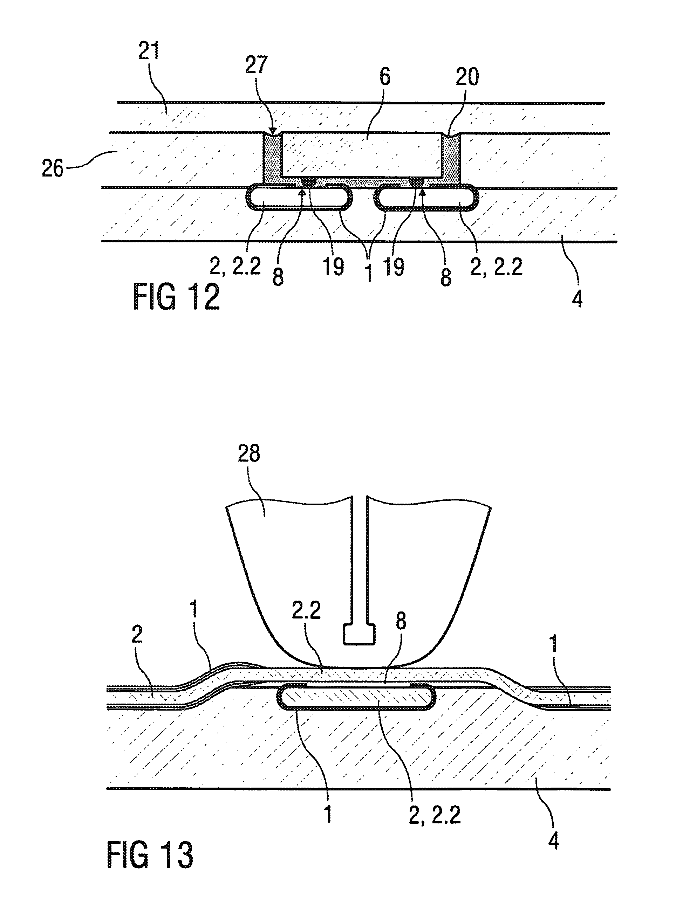

Fig. 12 gibt ein weiteres Beispiel eines auf der Oberfläche des thermoplastischen Substrates 4 befestigten und kontaktierten Bauelementes 6 wieder. Das Bauelement 6 ist mit vergoldeten Anschlusshügeln aus Nickel als Anschlüsse 19 versehen und mittels Klebstoff oder Vergussmasse 20 auf die Kontaktierbereiche 8, die Oberfläche des Substrates 4 und die noch isolierten Leiterbandabschnitte 2.2 geklebt und nach Aufsetzen einer beheizten Thermode auf die Rückseite des Bauelementes 6 endgültig befestigt und kontaktiert worden. Nach Auflegen einer zweiten, etwa chipdicken thermoplastischen Deckfolie 26, welche eine Aussparung 27 im Bereich des kontaktierten Bauelementes 6 aufweist, und deren partielles Anlaminieren an das Substrat 4 in einem Umgebungsbereich der Aussparung 27 wurde eine um das Bauelement 6 verbleibende Kavität mit härtendem Klebstoff oder Vergussmasse 20 ausgefüllt. Nach Auflegen der ersten, dünnen thermoplastischen Deckfolie 21 auf die zweite Deckfolie 26 und Laminieren entsteht das Vorlaminat in Fig. 12.

Ein Beispiel für die Kontaktierung zweier oder mehrerer auf einer Seite des Substrates 4 verlegter Schaltungsmuster 12 untereinander wird in Fig. 13 gezeigt. Beide sich kreuzenden Leiterbänder 2 sind in das Substrat 4 verlegt. Nur in einer Kreuzungsverbindungsstelle liegen die Leiterbandabschnitte 2.2 auf der Oberfläche des Substrates 4 auf. Der untere Leiterbandabschnitt 2.2 weist einen großflächige Kontaktierbereich 8 auf. Der obere Leiterbandabschnitt 2.2 führt über den unteren Leiterbandabschnitt 2.2 hinweg. Es ist die Situation wiedergegeben, da eine impulsgeheizte Schweißthermode 28 auf die Leiterbandabschnitte 2.2 aufsetzt, diese gegeneinander presst und mittels eines kurzen Schweißimpulses hoher Temperatur bzw. Energie miteinander verschweißt.

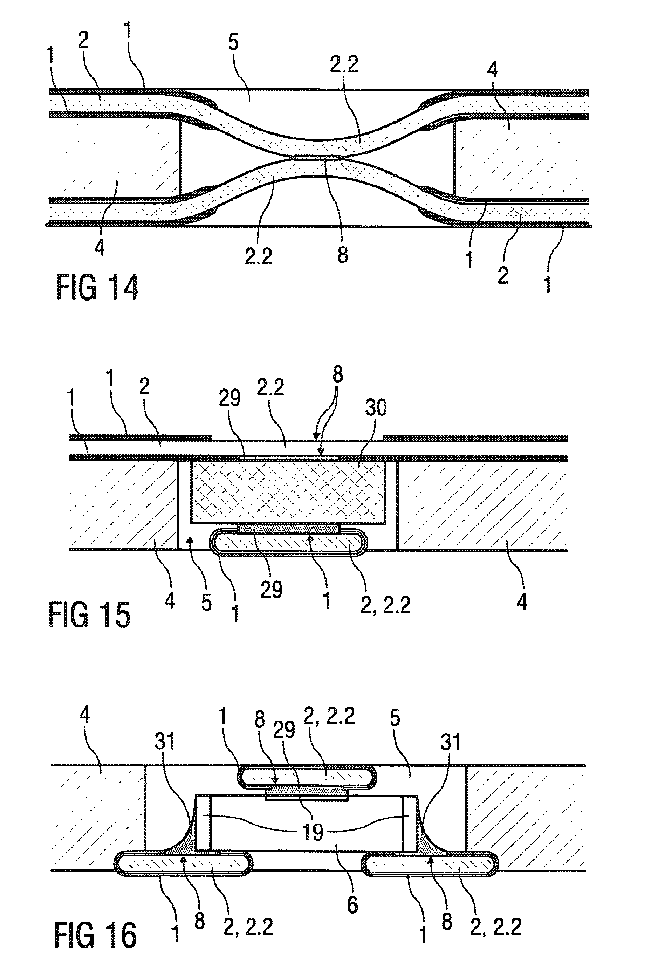

Einige Möglichkeiten der Verbindung von Leiterbandabschnitten 2.2, die Teil von Schaltungsmustern 12 sind, die auf beiden Seiten des Substrates 4 verlegt worden sind, zeigen die Figuren 14 und 15. Kontaktierbereiche 8 der Leiterbänder 2 sind miteinander verschweißt. Die Schweißverbindung in Fig. 14 ist sehr kostengünstig herstellbar. Die zu verbindenden Leiterbandabschnitte 2.2 beider Seiten des Substrates 4 sind über den Durchbruch 5 gezogen, im Durchbruch 5 zusammengedrückt und mittels impulsgeheizter Schweißthermode 28 ist die Schweißverbindung hergestellt. Dabei werden Ränder des Durchbruches 5 und die Leiterbandabschnitte 2.2 etwas deformiert.

Eine kostenaufwändigere Kontaktierung eines Leiterbandabschnittes 2.2 einer Seite des Substrates 4 mit dem Leiterbandabschnitt 2.2 der anderen Seite des Substrates 4 ist in Figur 15 gezeigt. Auf den Kontaktierbereich 8 des unten im Durchbruch 5 befindlichen Leiterbandabschnitts 2.2 ist elektrisch leitender Leitkleber 29 dosiert, und ein Metallstück 30 etwa der Flächengröße des Durchbruches 5 und der Dicke des Substrates 4 minus der Dicke der zu kontaktierenden beiderseits des Substrates 4 befindlichen Leiterbänder 2 ist in den Durchbruch 5 eingesetzt. Auf die obere Seite des Metallstückes 30 wird nun Leitkleber 29 dosiert und anschließend das obere Schaltungsmuster 12 verlegt und das zu kontaktierende Leiterband 2 über dem Leitkleber 29 positioniert. Der obere Leiterbandabschnitt 2.2 wird danach mittels eines starken, durch Laserstrahlung bewirkten thermischen Impulses beidseitig entisoliert. Nach Auflegen der ersten Deckfolien 21 auf beide Seiten des Substrates 4 erfolgt während des Laminierens das Andrücken der Leiterbänder 2 an den Leitkleber 29 bzw. an das Metallstück 30 und das Aushärten des Leitklebers 29 unter Herstellung der elektrischen Verbindung beider Schaltungsmuster 12.

Ein flaches elektronisches Bauelement 6 mit nach beiden Seiten des Substrates 4 weisenden Anschlüssen 19 wurde in Figur 16 auf zwei den Durchbruch 5 querende Leiterbänder 2, deren Kontaktierbereiche 8 mit Lotmaterial 31 versehen sind, platziert und anschließend so erhitzt, dass das Lotmaterial 31 die Anschlüsse 19 des elektronischen Bauelementes 6 mit den Kontaktierbereichen 8 der Leiterbänder 2 elektrisch und mechanisch verbindet. Auf den oberen Anschluss 19 des elektronischen Bauelementes 6 ist Leitkleber 29 dosiert worden. Nach Verlegen des Schaltungsmusters 12 auf der oberen Seite des Substrates 4 erfolgt das Entisolieren des vorgesehenen Kontaktierbereiches 8 mittels eines starken, durch Laserstrahlung bewirkten thermischen Impulses und die endgültige Kontaktierung durch Aufsetzen einer Thermode auf den Leiterbandabschnitt 2.2 über dem oberen Anschluss 19 des Bauelementes 6 und das Aushärten des Leitklebers 29.

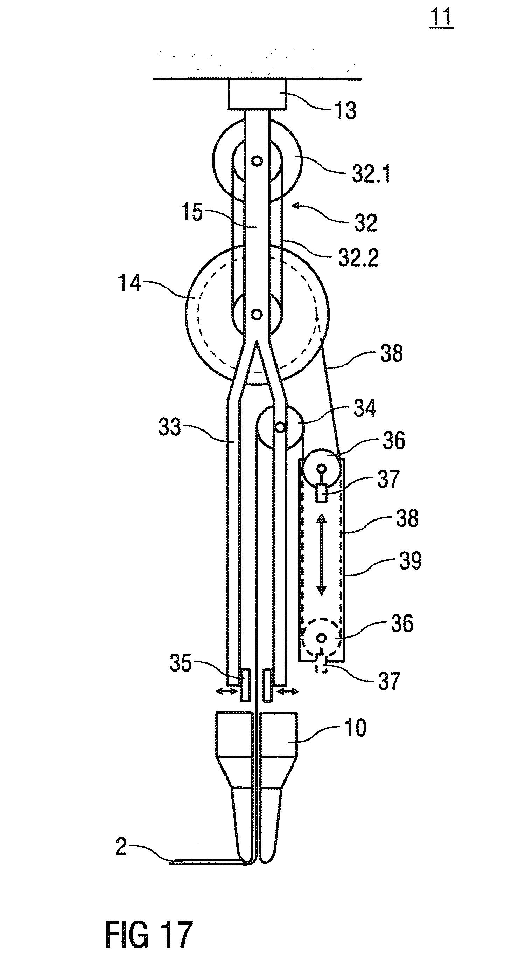

Figur 17 zeigt eine erfindungsgemäße Vorrichtung 11 zur Erzeugung eines Schaltungsmusters 12 auf einem Substrat 4, bei welcher die Leiterbandspule 14 mit einer Antriebseinheit 32 gekoppelt ist. Diese Antriebseinheit 32 ist im hier dargstellten Beispiel ebenfalls an der drehbaren Aufhängungsvorrichtung 13 oberhalb der Leiterbandspule 14 angeordnet und umfasst einen Motor 32.1 und einen Antriebsriemen 32.2 zur Kraftübertragung vom Motor 32.1 auf die Leiterbandspule 14.

Eine Halterung 33 ist mit der Spulenaufnahme 15 fest verbunden. Diese Halterung 33 weist eine leichtgängige Umlenkrolle 34 auf. Kurz über dem Verlegewerkzeug 10 mit Ultraschall-Schwinger, Konverter und Sonotrode ist eine Leiterbandklemme 35 befestigt. Zwischen der Umlenkrolle 34 und der Leiterbandspule 14 ist eine vertikal bewegliche weitere Umlenkrolle 36 angeordnet und weist ein Dämpfungsgewicht 37 auf. Mittels dieser weiteren Umlenkrolle 36 ist eine Leiterbandreserveschleife 38 erzeugbar.

Zur Überwachung der Lage/Länge der Leiterbandreserveschleife 38 bzw. der weiteren Umlenkrolle 36 ist ein nicht näher dargestellter Sensor angebracht. Die Leiterbandreserveschleife 38 befindet sich in einer Führungskammer 39. Dies ist nur eine beispielhafte Möglichkeit der Erzeugung einer Leiterbandreserveschleife 38. Über eine nicht dargestellte Sensorauswerteelektronik und Motorantriebselektronik sowie durch eine Auswertung eines zu verlegenden Leiterbandmusters auf dem Substrat 4 ist der Motor 32.1 und damit die Leiterbandspule 14 so antreibbar, dass stets eine ausreichende Leiterbandreserveschleife 38 vorhanden ist.

Sobald ein Leiterbandmuster verlegt ist, wird die Leiterbandreserveschleife 38 in Maximalstellung bewegt. Die Leiterbandabwicklung zur Bildung der Leiterbandreserveschleife 38 erfolgt unter Berücksichtigung des Verlegemusters so, dass außer in Verlegepausen die Leiterbandabwicklung weitgehend kontinuierlich erfolgt. Das Verlegewerkzeug 10 kann, wie hier dargestellt, ebenfalls an der Halterung 33 befestigt sein und sich mitdrehen, eine separate Aufhängung des Verlegewerkzeuges 10 ist jedoch zu bevorzugen, denn dies ermöglicht eine bessere Dynamik des Verlegewerkzeuges 10 insbesondere bei Bewegungen senkrecht zur Substratoberfläche, ermöglicht eine bessere Kraftsteuerung und ermöglicht eine gleichmäßigere Abnutzung der Wirkfläche des Verlegewerkzeuges 10.

Wesentlich ist, dass das Leiterband 2 knickfrei und ohne Führung über Umlenkkanten von der Umlenkspule 34 in das Verlegewerkzeug 10 fällt. Sobald ein Leiterbandmuster verlegt ist und das Verlegewerkzeug 10 unter Abheben von der Substratoberfläche eine andere Position einnehmen soll, muss zuvor die Leiterbandklemme 35 geschlossen werden, um ein Rückziehen des Leiterbandes 2 durch die vertikal bewegliche Umlenkrolle 36 oder eine Veränderung der Leiterbandlage im Verlegewerkzeugs 10 zu verhindern. Vor Verlegebeginn ist die Leiterbandklemme 35 wieder zu öffnen. Durch die beschriebene Vorgehensweise erfolgt eine verdrillungsfreie Leiterbandzuführung zum Verlegewerkzeug 10, wird eine vorgebbare und geringe Leiterbandvorspannung erhalten und das Leiterband 2 wird von der Leiterbandspule 14 auch bei Verlegegeschwindigkeiten im Bereich von 10 cm/s bis 100 cm/s und starken Geschwindigkeitsänderungen, beispielsweise aufgrund enger Radien oder Mäandermuster im Wesentlichen kontinuierlich abgespult. Es wird vermieden, das Leiterband 2 beim Abspulen längs zu dehnen und damit seine Geometrie, seine Festigkeit und seine elektrischen Kennwerte zu verändern.

### BEZUGSZEICHENLISTE

- 1: Isolierlack
- 1.1: Kernlackschicht
- 1.2: Backlackschicht
- 2: Leiterband
- 2.1: schmales Leiterband
- 2.2: Leiterbandabschnitt
- 3: Oberflächenschicht aus Edelmetall
- 4: Substrat
- 5: Durchbruch
- 6: Bauelement
- 7: musterartige Prägung
- 8: Kontaktierbereich
- 9: Umgebungsbereich
- 10: Verlegewerkzeug
- 11: Vorrichtung zur Erzeugung eines Schaltungsmusters
- 12: Schaltungsmuster
- 13: Aufhängungsvorrichtung
- 14: Leiterbandspule
- 15: Spulenaufnahme
- 16: Prägevorrichtung
- 16.1: fest stehender Amboss
- 16.2: beweglicher Amboss
- 17: Leiterbandführungsvorrichtung
- 17.1: fest montierte Umlenkrolle
- 17.2: bewegliche Umlenkrolle
- 18: Federlagerung
- 19: Anschlüsse
- 20: Klebstoff oder Vergussmasse
- 21: erste Deckfolie
- 22: Laminierstempel
- 23: Auflagetisch
- 24: Stempel
- 25: Chipkleber
- 26: zweite Deckfolie
- 27: Aussparung
- 28: Schweißthermode
- 29: Leitkleber
- 30: Metallstück
- 31: Lotmaterial
- 32: Antriebseinheit
- 32.1: Motor
- 32.2: Antriebsriemen
- 33: Halterung
- 34: leichtgängige Umlenkrolle
- 35: Leiterbandklemme
- 36: weitere Umlenkrolle
- 37: Dämpfungsgewicht
- 38: Leiterbandreserveschleife
- 39: Führungskammer

## Patentansprüche

1. Verfahren zur Erzeugung eines Schaltungsmusters (12) auf einem Substrat (4), wobei auf zumindest eine Oberflächenseite des Substrates (4) zumindest ein Leiterband (2, 2.1) verdrillungsfrei aufgebracht wird und wobei eine Leiterbandspule (14) verwendet wird, die um eine horizontale Drehachse drehbar gelagert in einer Spulenaufnahme (15) angeordnet ist, welche um eine vertikale Drehachse drehbar gelagert ist, wobei die Spulenaufnahme (15) mittels einer Nachführeinrichtung bei Richtungsänderungen während eines Verlegens des Leiterbandes (2, 2.1) auf dem Substrat (4) derart nachgedreht wird, dass das Leiterband (2, 2,.1) verdrillungsfrei tangential von der Leiterbandspule (14) abgespult wird,
**dadurch gekennzeichnet, dass** das zumindest eine Leiterband (2, 2.1), welches auf zumindest eine Oberflächenseite des Substrates (4) verdrillungsfrei aufgebracht wird, zumindest auf einer dem Substrat (4) zugewandten Oberflächenseite mit einem aufschmelzbaren Isolierlack (1) beschichtet ist, wobei der Isolierlack (1) mittels Ultraschall erwärmt und zumindest teilweise aufgeschmolzen wird und das Leiterband (2, 2.1) verdrillungsfrei auf das Substrat (4) aufgepresst wird, wobei das Leiterband (2, 2.1) mittels eines zylinderförmigen oder konischen ultraschallangeregten Verlegewerkzeugs (10) verlegt wird, welches zumindest über einen Teil seiner Länge eine das Leiterband (2, 2.1) führende Innenbohrung und eine ringförmige, in Innen- und Außenradius übergehende, senkrecht zu seiner Längsachse angeordnete Wirkfläche aufweist, wobei mittels einer zwischen einer Umlenkrolle (34), welche an einer mit der Spulenaufnahme (15) fest verbundenen Halterung (33) angeordnet ist, und der Leiterbandspule (14) angeordneten vertikal beweglichen weiteren Umlenkrolle (36) mit einem Dämpfungsgewicht eine Leiterbandreserveschleife (38) erzeugt wird.

2. Verfahren nach Anspruch 1,
**dadurch gekennzeichnet, dass** das Substrat vor dem Aufbringen des Leiterbandes zumindest in einem Bereich des zu erzeugenden Schaltungsmusters vorgewärmt wird.

3. Verfahren nach Anspruch 1 oder 2,
**dadurch gekennzeichnet, dass** eine Oberfläche des Substrates (4) durch thermische Energie oder mittels Ultraschall erwärmt und zumindest teilweise aufgeschmolzen wird und das Leiterband (2, 2.1) unter Verdrängung und/oder Verdichtung eines Materials des Substrates (4) zumindest teilweise in das Substrat (4) hineingepresst wird.

4. Verfahren nach einem der Ansprüche 1 bis 3,
**dadurch gekennzeichnet, dass** das Verlegewerkzeug (10) relativ zum Substrat (4) und/oder das Substrat (4) relativ zum Verlegewerkzeug (10) bewegt wird.

5. Verfahren nach einem der Ansprüche 1 bis 4,
**dadurch gekennzeichnet, dass** nach Verlegen des Leiterbandes (2, 2.1) Kontaktierbereiche (8) des Leiterbandes (2, 2.1) entisoliert werden.

6. Verfahren nach einem der Ansprüche 1 bis 5,
**dadurch gekennzeichnet, dass** das Leiterband (2, 2.1) oder eine Mehrzahl von Leiterbändern (2, 2.1) auf einer Oberflächenseite des Substrates (4) sich selbst und/oder sich gegenseitig kreuzend aufgebracht werden.

7. Verfahren nach einem der Ansprüche 1 bis 6,
**dadurch gekennzeichnet, dass** ein Durchbruch (5) im Substrat (4) mittels einer ersten Deckfolie (21) auf einer Oberflächenseite des Substrates (4), auf welcher das Schaltungsmuster (12) angeordnet ist, einseitig verschlossen wird, in eine **dadurch** gebildete Kavität Klebstoff oder Vergussmasse (20) dosiert wird, ein elektronisches Bauelement (6) in die Kavität eingesetzt und mit Anschlüssen (19) gegen Kontaktierbereiche (8) des Leiterbandes (2, 2.1) gedrückt wird, eine weitere erste Deckfolie (21) auf eine Oberflächenseite des Substrates (4) ohne Schaltungsmuster (12) aufgelegt wird und in einem gemeinsamen Verfahrensschritt die beiden ersten Deckfolien (21) und das Substrat mit auf- oder eingebrachtem Schaltungsmuster (12) und darin eingesetztem elektronischen Bauelement (6) unter Zusammenpressen laminiert wird, wobei die Anschlüsse (19) des elektronischen Bauelements (6) an die Kontaktierbereiche (8) angedrückt und kontaktiert werden und der Klebstoff oder die Vergussmasse (20) bei Laminiertemperatur ausgehärtet wird.

8. Verfahren nach einem der Ansprüche 1 bis 6,
**dadurch gekennzeichnet, dass** auf beiden Oberflächenseiten des Substrates (4) Leiterbänder (2, 2.1) aufgebracht werden und durch einen Durchbruch (5) im Substrat (4) hindurch elektrisch miteinander verbunden werden.

9. Vorrichtung (11) zur Erzeugung eines Schaltungsmusters (12) auf einem Substrat (4), umfassend eine Leiterbandspule (14),
wobei die Leiterbandspule (14) um eine horizontale Drehachse drehbar gelagert in einer Spulenaufnahme (15) angeordnet ist, welche um eine vertikale Drehachse drehbar gelagert ist, wobei die Spulenaufnahme (15) mittels einer Nachführeinrichtung bei Richtungsänderungen während eines Verlegens des Leiterbandes (2, 2.1) auf dem Substrat (4) derart nachdrehbar ist, dass das Leiterband (2, 2,.1) verdrillungsfrei tangential von der Leiterbandspule (14) abspulbar ist,
**dadurch gekennzeichnet, dass** die Vorrichtung (11) ein zylinderförmiges oder konisches ultraschallangeregtes Verlegewerkzeug (10) umfasst, welches zumindest über einen Teil seiner Länge eine das Leiterband (2, 2.1) führende Innenbohrung und eine ringförmige, in Innen- und Außenradius übergehende, senkrecht zu seiner Längsachse angeordnete Wirkfläche aufweist, und dass die Vorrichtung (11) eine mit der Spulenaufnahme (15) fest verbundene Halterung (33) mit einer Umlenkrolle (34) aufweist, wobei zwischen der Umlenkrolle (34) und der Leiterbandspule (14) eine vertikal bewegliche weitere Umlenkrolle (36) mit einem Dämpfungsgewicht angeordnet ist, mittels welcher eine Leiterbandreserveschleife (38) erzeugbar ist.

10. Vorrichtung (11) nach Anspruch 9,
**dadurch gekennzeichnet, dass** die Leiterbandspule (14) mit einer Antriebseinheit (32) gekoppelt ist.

## Claims

1. Method for producing a circuit pattern (12) on a substrate (4), wherein at least one conductor strip (2, 2.1) is attached in a twist-free manner on at least one surface side of the substrate (4), and wherein a conductor strip coil (14) is used, which is arranged in a pivoted manner about a horizontal axis of rotation in a coil receptacle (15) which is pivoted about a vertical axis of rotation, wherein the coil receptacle (15) can be turned by means of a tracker device in the case of changes in direction during a laying of the conductor strip (2, 2.1) on the substrate (4) such that the conductor strip (2, 2.1) can be unwound in a twist-free manner tangentially from the conductor strip coil (14),
**characterized in that**
the at least one conductor strip (2, 2.1) which is attached in a twist-free manner on at least one surface side of the substrate (4) is coated with a meltable insulating varnish (1) at least on one surface side facing towards the substrate (4), wherein the insulating varnish (1) is heated by means of ultrasound and is at least partially melted, and the conductor strip (2, 2.1) is pressed onto the substrate (4) in a twist-free manner, wherein the conductor strip (2, 2.1) is laid by means of a cylindrical or conical laying tool (10) which is excited by ultrasound and which at least over a part of its length has an interior bore guiding the conductor strip (2, 2.1) and an annular active area merging in inner and outer radius and being arranged perpendicular to its longitudinal axis, wherein a conductor strip reserve loop (38) is produced by means of a vertically movable further deflection roller (36) having a damper weight and being arranged between a deflection roller (34), which is arranged at a holder (33) being fixedly connected to the coil receptacle (15), and the conductor strip coil (14).

2. Method according to claim 1,
**characterized in that**
before the application of the conductor strip, the substrate is pre-heated at least in one region of the circuit pattern to be produced.

3. Method according to claim 1 or 2,
**characterized in that**
a surface of the substrate (4) is heated by thermal energy or by means of ultrasound and is at least partially melted, and the conductor strip (2, 2.1) is pressed at least partly into the substrate (4) with displacement and/or compression of a material of the substrate (4).

4. Method according to one of claims 1 through 3,
**characterized in that**
the laying tool (10) is moved relative to the substrate (4) and/or the substrate (4) is moved relative to the laying tool (10).

5. Method according to one of claims 1 through 4,
**characterized in that**
after the laying of the conductor strip (2, 2.1), contacting regions (8) of the conductor strip (2, 2.1) are stripped of insulation.

6. Method according to one of claims 1 through 5,
**characterized in that** the conductor strip (2, 2.1) or a plurality of conductor strips (2, 2.1) are applied onto a surface side of the substrate (4) crossing themselves and/or crossing one another.

7. Method according to one of claims 1 through 6,
**characterized in that**
a through hole (5) in the substrate (4) is closed on one side by means of a first cover film (21) on a surface side of the substrate (4) on which the circuit pattern (12) is arranged, adhesive or potting material (20) is measured into a cavity formed thereby, an electronic component (6) is placed into the cavity and is pressed with contacts (19) against contacting regions (8) of the conductor strip (2, 2.1), a further first cover film (21) is placed onto a surface side of the substrate (4) without circuit pattern (12), and in a joint process step the two first cover films (21) and the substrate with the circuit pattern (12) arranged thereon or therein and the electronic component (6) placed therein are laminated with compression, wherein the contacts (19) of the electronic component (6) are pressed against the contacting regions (8) and are contacted and the adhesive or the potting material (20) is cured at laminating temperature.

8. Method according to one of claims 1 through 6,
**characterized in that**
conductor strips (2, 2.1) are arranged on both surface sides of the substrate (4) and are electrically connected to one another through a through hole (5) in the substrate (4).

9. Device (11) for producing a circuit pattern (12) on a substrate (4), comprising a conductor strip coil (14), wherein the conductor strip coil (14) is arranged in a pivoted manner about a horizontal axis of rotation in a coil receptacle (15) which is pivoted about a vertical axis of rotation, wherein the coil receptacle (15) can be turned by means of a tracker device in the case of changes in direction during a laying of the conductor strip (2, 2.1) on the substrate (4) such that the conductor strip (2, 2.1) can be unwound in a twist-free manner tangentially from the conductor strip coil (14), **characterized in that**
the device (11) has a cylindrical or conical laying tool (10) which is excited by ultrasound and which at least over a part of its length has an interior bore guiding the conductor strip (2, 2.1) and an annular active area merging in inner and outer radius and being arranged perpendicular to its longitudinal axis, and the device (11) has a holder (33) being fixedly connected to the coil receptacle (15) and having a deflection roller (34), wherein a vertically movable further deflection roller (36) having a damper weight is arranged between the deflection roller (34) and the conductor strip coil (14), wherein a conductor strip reserve loop (38) can be produced by means of said further deflection roller (36).

10. Device (11) according to claim 9,
**characterized in that**
the conductor strip coil (14) is coupled to a drive unit (32).

## Revendications

1. Procédé pour la fabrication d'un motif de circuit (12) sur un substrat (4), au moins une bande conductrice (2, 2.1) étant fixée d'une manière sans torsion sur au moins un côté de surface du substrat (4), une bobine de bande conductrice (14) étant utilisée, qui est agencée de manière pivotante autour d'un axe de rotation horizontal dans un récipient de bobine (15) étant pivoté autour d'un axe de rotation vertical, le récipient de bobine (15) pouvant être tourné au moyen d'un dispositif de suivi en cas de changements de direction pendant la pose de la bande conductrice (2, 2.1) sur le substrat (4) de telle manière que la bande conductrice (2, 2.1) puisse être déroulée d'une manière sans torsion tangentiellement à partir de la bobine de bande conductrice (14),
**caractérisé en ce que**
ladite au moins une bande conductrice (2, 2.1) étant fixée d'une manière sans torsion sur au moins un côté de surface du substrat (4) est revêtue d'un vernis isolant fusible (1) au moins sur un côté de surface étant tourné vers le substrat (4), le vernis isolant (1) étant chauffé au moyen d'ultrasons et étant au moins partiellement fondu, et la bande conductrice (2, 2.1) étant pressée sur le substrat (4) d' une manière sans torsion, la bande conductrice (2, 2.1) étant posée au moyen d'un outil de pose (10) de forme cylindrique ou conique, qui est excité par ultrasons et qui, au moins sur une partie de sa longueur, présente un alésage intérieur guidant la bande conductrice (2, 2.1) et une zone active de forme annulaire fusionnant dans le rayon intérieur et extérieur et étant disposée perpendiculairement à son axe longitudinal, une boucle de réserve de bande conductrice (38) étant fabriquée au moyen d'un rouleau de déviation (36) additionnel étant verticalement mobile et présentant un poids d'amortissement et étant disposé entre un rouleau de déviation (34), qui est agencé à un support (33) étant relié de manière fixe au récipient de bobine (15), et la bobine de bande conductrice (14).

2. Procédé selon la revendication 1,
**caractérisé en ce que**
le substrat est préchauffé au moins dans une région du motif de circuit à fabriquer avant l'application de la bande conductrice.

3. Procédé selon la revendication 1 ou 2,
**caractérisé en ce qu'**
une surface du substrat (4) est chauffée par l'énergie thermique ou au moyen d'ultrasons et est au moins partiellement fondue, et **en ce que** la bande conductrice (2, 2.1) est pressée au moins partiellement dans le substrat (4) avec déplacement et/ou compression d'un matériau du substrat (4).

4. Procédé selon l'une quelconque des revendications 1 à 3,
**caractérisé en ce que**
l'outil de pose (10) est déplacé par rapport au substrat (4) et/ou le substrat (4) est déplacé relativement à l'outil de pose (10).

5. Procédé selon l'une quelconque des revendications 1 à 4,
**caractérisé en ce que**
des zones de contact (8) de la bande conductrice (2, 2.1) sont dénudées de leur isolation suite à la pose de la bande conductrice (2, 2.1 ).

6. Procédé selon l'une quelconque des revendications 1 à 5,
**caractérisé en ce que**
la bande conductrice (2, 2.1) ou une pluralité de bandes conductrices (2. 2.1) est/sont appliquée/s sur un côté de surface du substrat (4) de manière à se croiser elles-mêmes et/ou de manière à se croiser les unes les autres.

7. Procédé selon l'une quelconque des revendications 1 à 6,
**caractérisé en ce qu'**
un trou traversant (5) dans le substrat (4) est fermé d'un côté au moyen d'un premier film de recouvrement (21) sur un côté de surface du substrat (4) sur lequel le motif de circuit (12) est agencé, un matériau adhésif ou un matériau d'enrobage est introduit de manière dosée dans une cavité ainsi formée, un composant électronique (6) est placé dans la cavité et est pressé avec des contacts (19) contre des zones de contact de la bande conductrice (2, 2.1), un premier film de recouvrement (21) additionnel est placé sur un côté de surface du substrat (4) sans motif de circuit (12), et les deux premiers films de recouvrement (21) et le substrat ayant le motif de circuit (12) appliqué dessus ou bien dedans et ayant le composant électronique (6) placé dedans sont laminés avec compression dans une étape de processus commune, les contacts (19) du composant électronique (6) étant pressés contre les zones de contact (8) et étant contactés et le matériau adhésif ou le matériau d'enrobage étant durci à une température de laminage.

8. Procédé selon l'une quelconque des revendications 1 à 6,
**caractérisé en ce que**
des bandes conductrices (2, 2.1) sont agencées sur les deux côtés de surface du substrat (4) et sont électriquement reliées entre elles via un trou traversant (5) dans le substrat (4).

9. Dispositif (11) pour la fabrication d'un motif de circuit (12) sur un substrat (4), comprenant une bobine de bande conductrice (14), la bobine de bande conductrice (14) étant agencée de manière pivotante autour d'un axe de rotation horizontal dans un récipient de bobine (15) étant pivoté autour d'un axe de rotation vertical, le récipient de bobine (15) pouvant être tourné au moyen d'un dispositif de suivi en cas de changements de direction pendant la pose de la bande conductrice (2, 2.1) sur le substrat (4), de telle manière que la bande conductrice (2, 2.1) puisse être déroulée d'une manière sans torsion tangentiellement à partir de la bobine de bande conductrice (14), **caractérisé en ce que**
le dispositif (11) présente un outil de pose (10) de forme cylindrique ou conique qui est excité par ultrasons et qui, au moins sur une partie de sa longueur, présente un alésage intérieur guidant la bande conductrice (2, 2.1) et une zone active de forme annulaire fusionnant dans le rayon intérieur et extérieur et étant disposée perpendiculairement à son axe longitudinal, et **en ce que** le dispositif (11) présente un support (33) étant relié de manière fixe au récipient de bobine (15) et présentant un rouleau de déviation (34), dans lequel un rouleau de déviation (36) additionnel étant verticalement mobile et présentant un poids d'amortissement est disposé entre le rouleau de déviation (34) et la bobine de bande conductrice (14), une boucle de réserve de bande conductrice (36) pouvant être fabriquée au moyen dudit rouleau de déviation (36).

10. Dispositif (11) selon la revendication 9,
**caractérisé en ce que**
la bobine de bande conductrice (14) est couplée à une unité d'entraînement (32).
